Europäisches Patentamt

European Patent Office

Office européen des brevets

(11) Publication number: **0 580 337 A2**

# EUROPEAN PATENT APPLICATION

(21) Application number: **93305450.4**

(22) Date of filing: **13.07.93**

(51) Int. Cl.⁵: **G06F 1/32**, **H03K 19/00**

(30) Priority: **21.07.92 US 917488**

(43) Date of publication of application:
**26.01.94 Bulletin 94/04**

(84) Designated Contracting States:
**BE DE DK ES FR GB GR IE IT LU NL PT**

(71) Applicant: **ADVANCED MICRO DEVICES, INC.**
**901 Thompson Place**
**P.O. Box 3453**
**Sunnyvale, CA 94088(US)**

(72) Inventor: **Bowles, James E.**
**11716 Birchbark Trail**
**Austin, Texas 78750(US)**
Inventor: **O'Brien, Robert**
**4210 Harcourt Drive**
**Austin, Texas 78727(US)**

(74) Representative: **BROOKES & MARTIN**
**High Holborn House**
**52/54 High Holborn**
**London, WC1V 6SE (GB)**

(54) Pull-up disable mechanisms for microcontrollers in integrated circuits.

(57) A weak pull-up disable method and mechanism therefor for use in association with a microcontroller incorporated in an integrated circuit. The weak pull-up disable mechanism is incorporated in the integrated circuit containing the microcontroller. The mechanism disables the weak pull-ups of I/O buffers of the microcontroller. The weak pull-ups serve to pull the voltage of the associated ports high. By so disabling the weak pull-ups, the need for a driver to sink the current when in input mode is eliminated. Elimination of the need for an external driver due to the weak pull-up disable mechanism reduces power consumption by the integrated circuit.

EP 0 580 337 A2

This application is related to the following copending US and equivalent European Patent Applications filed today:

| US Application No. | European Patent Application No | Our Reference |
|---|---|---|
| 07/917,497 | | HRW/TT0139/BEP |
| 07/917,489 | | HRW/TT0140/BEP |
| 07/917,503 | | PCCS/TT0142/SMP |
| 07/918,627 | | HRW/TT0143/BEP |
| 07/918,626 | | PCCS/TT0144/SMP |
| 07/918,625 | | PCCS/TT0145/SMP |
| 07/918,624 | | PCCS/TT0146/SMP |
| 07/918,631 | | HRW/TT0147/BEP |
| 07/918,632 | | PCCS/TT0148/SMP |
| 07/918,622 | | PCCS/TT0149/SMP |
| 07/918,621 | | PCCS/TT0150/SMP |

All of the related applications are hereby incorporated herein in their entirety by this reference thereto.

The present invention relates to a method for a weak pull-up disable (WPUD) and the mechanism therefor for use in connection with a microcontroller in an integrated circuit (IC) and, more particularly, to such a WPUD method and mechanism for use in connection with a microcontroller in an IC involved with the speech, control channel, or microcontroller portions of a modem, or with the man-machine interface functions of a cordless telephone.

Microcontrollers are employed in a wide variety of digital electronics devices. Generally, microcontrollers are incorporated in ICs where they function to control the particular electrical flow through the IC circuitry. Circuitry of ICs is varied in order to accomplish desired functions.

In an IC, a microcontroller incorporated therein controls the electrical flow through the IC circuitry by electrically communicating with the circuitry of the IC through Input/Output (I/O) ports of the microcontroller. The I/O ports are electrically connected with devices, either incorporated in the IC or otherwise external to the microcontroller, for such communication. The electrical connection is typically by means of a bus, a group of parallel conductive lines that connect the microcontroller ports to the IC circuitry and the other devices.

Electrical current is directed and received by the microcontroller to or from particular ports of the microcontroller, and thus to or from particular bus lines and particular devices within and external to the IC. Electrical current passes through the IC and microcontroller circuitry in discrete units, or bits, which may, at any point in the circuitry, be either high or low voltage, representing a logic 1 or logic 0, respectively. The particular paths of the discrete units and choice of high or low voltage signals is regulated by the microcontroller to accomplish desired functions in the IC circuitry.

In order that the microcontroller may pass and receive electrical signals to and from the IC circuitry and other devices external to the microcontroller, the microcontroller must have both voltage level and current drive compatibility with the IC circuitry and the other devices. Standard voltage ranges corresponding to logic 1 and logic 0 have been followed for most IC devices. As hereinafter described, generally two sets of voltage ranges are defined, one for inputs and one for outputs. In addition to particular voltages, input and output current requirements must be compatible for passing and receiving electrical signals.

Microcontrollers often contain buffers associated with the I/O ports. Input buffers in microcontrollers buffer input voltages from IC circuitry and other devices and shift the input voltages to the internal voltage levels required by the microcontroller. Output buffers transform the microcontroller's internal voltage levels to those compatible with output logic levels required by the IC circuitry and other external devices.

Ports of microcontrollers may be bi-directional in that they may serve both for input and for output. As previously briefly addressed, both voltages and current drive of the microcontroller must be compatible with

2

the other devices for input and output, and buffers, associated with the I/O parts, often serve to shift and transform the voltages and current drive to compatible levels. In order for a port to serve both for input and output (i.e., as a "bi-directional port"), the microcontroller must be able to discriminate between input and output. One method employed in microcontrollers for accomplishing this discrimination is to define two different sets of voltage ranges, one for input and one for output. Within each of these sets of voltage ranges, the voltage then varies high to low to represent logic 1 and logic 0, respectively. These two different sets of voltage ranges may be defined in a number of different manners depending upon the electrical configuration of the ports and the characteristics of the microcontroller.

Certain types of microcontrollers (e.g., the 8-bit 80C51 family of Advanced Micro Devices (AMD) products), include pull-ups and drivers associated with buffers of the I/O ports of the microcontrollers. A "pull-up", or pullup resistor as it is also called, is a resistor that ensures that an otherwise open circuit will be maintained at a particular, desired voltage level relative to a source voltage. A driver is a device which is able to source, or provide, the current required by inputs it drives at the logic 1 level without its output voltage rising above the particular compatible voltage level. In the logic 0 case, the driver must be able to sink, or accept, the input current from the device being driven without its output voltage rising above the particular compatible voltage level. Pull-ups are often employed to cause the buffers to adjust voltage levels of input or output signals to compatible levels. The drivers, generally being separate drivers for input and output, are typically employed to maintain current drive at compatible levels.

One problem with this pull-up/external driver arrangement in microcontrollers is that it may cause unnecessary burning of power when the driver is creating a sink for the input current from the device being driven while the pull-up is simultaneously pulling the pin high voltage. To limit this unnecessary power consumption during input mode, the present invention provides a weak pull-up disable method and mechanism. The mechanism serves to disable the weak pull-ups of a microcontroller during input mode. By disabling the weak pull-ups, less power is consumed by the external driver during input mode. As is apparent, this weak pull-up disable of the present invention represents an improved alternative yielding reduced power consumption.

One particular application for which the WPUD method and mechanism for use in connection with a microcontroller incorporated in an IC is well-suited is a cordless telephone. Cordless telephones may be contrasted with standard telephones in several respects. The standard telephone consists of a base unit and a handset unit connected to each other by an electrical cord. The base unit itself is connected by another cord to a receptacle on a wall, telephone pole or a similar immovable structure to which the telephone network line extends. Because of this connection to an immovable structure, the range of movement of the operator of the telephone is quite limited. Even when the cords connecting the handset unit to the base unit and the base unit to the wall are long, it can be cumbersome either to move the entire telephone around to make calls from different locations or to walk around with the handset unit once a call has been placed. The simple fact that there is always a continuous physical connection between the person making the phone call and the immovable wall or other fixed structure can be a great inconvenience.

The cordless telephone, on the other hand, represents a significant improvement over the standard telephone. In the conventional cordless telephone, the base unit is still connected to the receptacle on the immovable wall or the like by a cord so that message signals from the telephone network line may be received and transmitted. However, the handset unit of the cordless telephone is an independently operative unit from which calls may be made and by which calls may be received with no physical connection to the base unit. The handset unit has a transmitting/receiving system or transceiver, a loudspeaker in an earpiece and a microphone in a mouthpiece. The base unit and the handset unit of the cordless telephone communicate with each other over a communication channel established by the transmission and reception of electromagnetic waves, conventionally radio waves. The handset unit may then be taken considerable distances from the base unit while still making and receiving telephone calls. Since there is no telephone cord extending between the handset unit and the base unit, the operator is free to move about without hindrance.

Heretofore, IC's which incorporate microcontrollers have been developed and used in cordless telephones to perform various functions. There are, however, a number of aspects of IC's in such phones that can be improved. One such aspect includes a WPUD method and mechanism for use in connection with weak pull-ups of microcontroller I/O ports and buffers, which method and mechanism are incorporated in the design of the IC which includes the microcontroller. Such a method and mechanism limits power consumption of external drivers which have heretofore been used to provide for the input capability now provided by the WPUD method and mechanism.

Based upon the foregoing, those skilled in the art should now perceive that a WPUD method and mechanism incorporated in the design of an IC with a microcontroller, for example, an IC for use in cordless telephones, is an improvement over the existing technology. It is a shortcoming and deficiency of the prior art that such an improvement has not previously been conceived.

To overcome the aforementioned shortcomings and deficiencies, we describe a WPUD method and mechanism incorporated in the circuitry of an IC including a microcontroller. More particularly, we describe such a WPUD method and mechanism incorporated in a single IC having a microcontroller, which IC is designed to be installed in both the base unit and handset unit of a cordless telephone and integrates the speech, control channels, and microcontroller portions of a modem, and the man-machine interface functions of a cordless telephone.

In one aspect, we describe an integrated circuit including a microcontroller having at least one output buffer with a weak pull-up and a means for disabling the pull-up.

In the above-described integrated circuit, the means for disabling is preferably incorporated in the circuitry of the integrated circuit.

In the above-described integrated circuit the means for disabling when activated preferably eliminates the need for a driver to sink current of the pull-up.

In the above-described integrated circuit the microcontroller is preferably an 8051 model microcontroller.

In the above-described integrated circuit the means for disabling is preferably activated through software control.

In the integrated circuit described above, the output buffer with a weak pull-up is preferably configured with a port pin, and the means for disabling is preferably activated through software control, the software control activating the means for disabling by configuring the port pin with a corresponding port control register bit to an appropriate value.

In another aspect, we describe a method for reducing power consumption by an integrated circuit incorporating a microcontroller, comprising the step of disabling a weak pull-up associated with an output buffer of the microcontroller.

The step of disabling is preferably by software control.

The step of disabling is preferably by configuring a port pin associated with the buffer with a corresponding port control register bit to an appropriate value.

The method described above preferably includes the step of eliminating a driver which serves to sink the current of said pull-up in input mode.

In the accompanying drawings, by way of example only:-

FIG. 1 is a possible structure for port bit latches and I/O buffers in a microcontroller and, in particular, with respect to Ports 0, 1, 2 and 3 of an 8051 microcontroller;

FIG. 2 is a possible structure for NMOS and CMOS internal pull-up configurations and, in particular, such an arrangement found in Ports 1 and 3 of an 8051 microcontroller;

FIG. 3 (which consists of FIG. 3a and FIG. 3b) is a block diagram of an exemplary IC which includes a WPUD method and mechanism associated with the IC microcontroller according to the teachings of the present invention;

FIG. 4 is a block diagram of a handset unit of a cordless telephone into which an exemplary IC which includes a WPUD method and mechanism associated with the IC microcontroller according to the teachings of the present invention has been installed;

FIG. 5 is a block diagram of a base unit of a cordless telephone into which an exemplary IC which includes a WPUD method and mechanism associated with the IC microcontroller according to the teachings of the present invention has been installed;

FIG. 6 is a block diagram of a microcontroller system that may form part of an exemplary IC which includes a WPUD method and mechanism associated with the IC microcontroller according to the teachings of the present invention;

FIG. 7 is a block diagram of a clock generator module that may form part of an exemplary IC which includes a WPUD method and mechanism associated with the IC microcontroller according to the teachings of the present invention;

FIG. 8 is a possible structure for an interrupt controller that may form part of an exemplary IC which includes a WPUD method and mechanism associated with the IC microcontroller according to the teachings of the present invention;

FIG. 9 shows a possible structure of the status, mask, and source registers necessary to handle interrupt cause signals from a logic module in an exemplary IC which includes a WPUD method and mechanism associated with the IC microcontroller according to the teachings of the present invention;

FIG. 10 shows a state diagram of a watchdog timer and a reset output mechanism that may form part of an exemplary IC which includes a WPUD method and mechanism of the present invention;

FIG. 11 shows a possible organization of a watchdog timer that may form part of an exemplary IC which includes a WPUD method and mechanism associated with the IC microcontroller according to the teachings of the present invention;

FIG. 12 shows a possible basic structure of an interrupt function mechanism that may form part of an exemplary IC which includes a WPUD method and mechanism associated with the IC microcontroller according to the teachings of the present invention;

FIG. 13 shows an external interrupt input structure that may be present in an exemplary IC including the WPUD method and mechanism;

FIG. 14 shows a block diagram of a serial interface that may be present in an exemplary IC including the WPUD method and mechanism of the present invention;

FIG. 15 is a block diagram of a keypad scanner that may form part of an exemplary IC which includes a WPUD method and mechanism associated with the IC microcontroller according to the teachings of the present invention;

FIG. 16 is a block diagram of a real-time clock module that may form part of an exemplary IC which includes a WPUD method and mechanism associated with the IC microcontroller according to the teachings of the present invention;

FIG. 17 is a block diagram of a battery level detector that may form part of an exemplary IC which includes a WPUD method and mechanism associated with the IC microcontroller according to the teachings of the present invention;

FIG. 18 shows various CT2 modules that may form part of an exemplary IC which includes a WPUD method and mechanism associated with the IC microcontroller according to the teachings of the present invention;

FIG. 19 is a block diagram of a transmit modulator that may form part of an exemplary IC which includes a WPUD method and mechanism associated with the IC microcontroller according to the teachings of the present invention;

FIG. 20 is a block diagram of a frame controller that may form part of an exemplary IC which includes a WPUD method and mechanism associated with the IC microcontroller according to the teachings of the present invention;

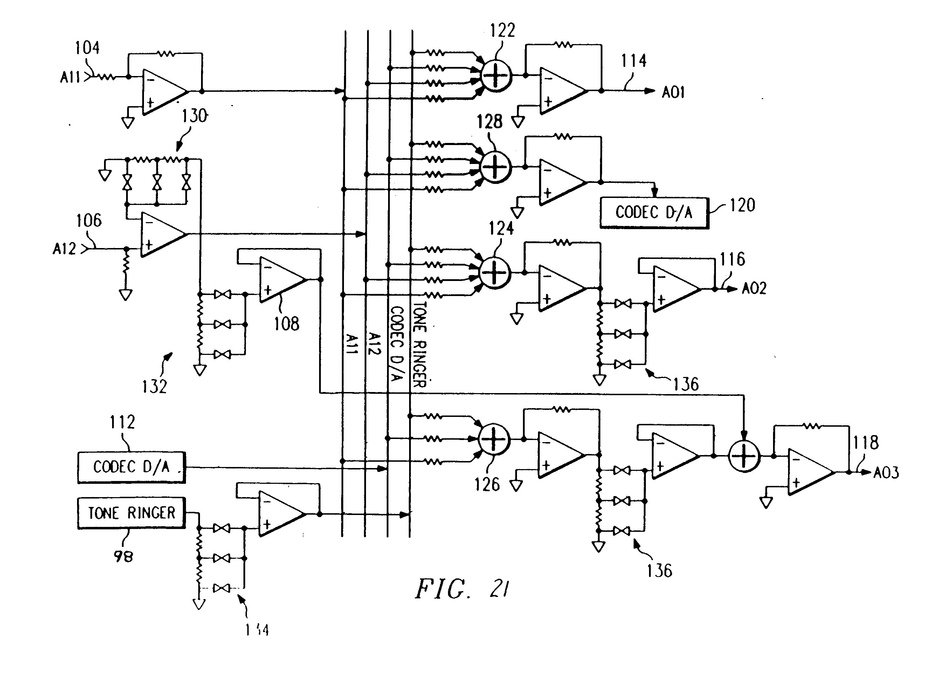

FIG. 21 is a block diagram of an audio interface of a cordless telephone into which the exemplary IC's have been incorporated (hereinafter, "a cordless telephone"); and

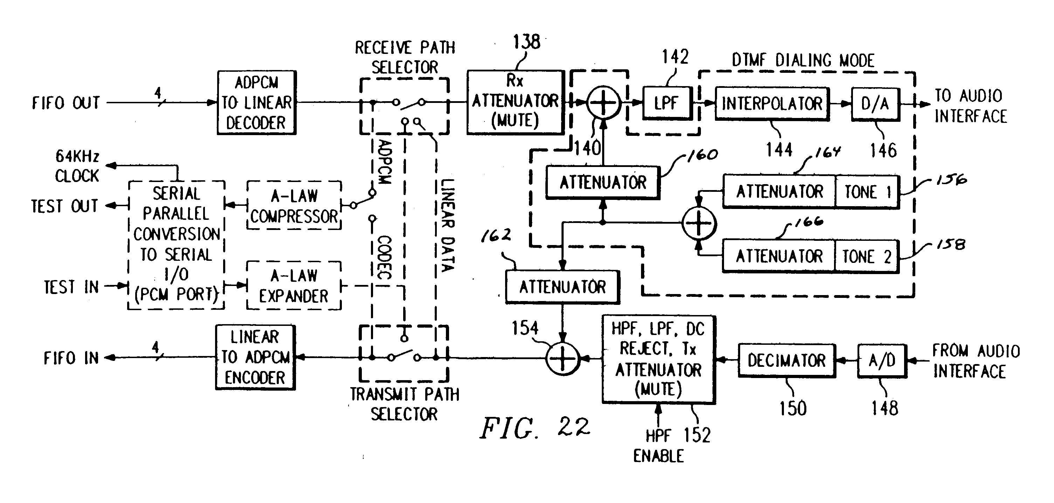

FIG. 22 is a block diagram of the audio path of a cordless telephone, excluding the analog interface.

In the detailed description that follows, to facilitate understanding of the present invention, and as an example only, an embodiment of the WPUD method and mechanism associated with an exemplary microcontroller incorporated into an exemplary IC for use with a cordless telephone system is precisely described. It should be expressly understood that the present invention is not necessarily limited to that application, although the invention has been found to work especially well in actual practice when so used. Further, it should also be expressly understood that a multitude of different embodiments of the present invention could be employed in the particular application described; as is typical and understood, the present invention is limited solely by the scope of the appended claims.

## GENERAL DESCRIPTION OF WEAK PULL-UP DISABLE MECHANISM

The WPUD method and mechanism of the present invention are incorporated in the circuitry of an IC. The method and mechanism serve to disable weak pull-ups associated with the buffers of a microcontroller of the IC. Incorporating the method and mechanism into IC circuitry in accordance with the teachings of the present invention eliminates the need for external drivers to sink the current of the weak pull-ups so that the associated ports may serve for input, and therefore results in considerable power savings.

The weak pull-ups serve to cause the buffers of the microcontroller to be maintained at a constant voltage, relative to the source voltage, desired for output mode. In prior practice, an external driver was used to sink the current of the weak pull-ups thereby lowering the voltage of the buffers and enabling the buffers and associated ports to then serve for input when the external drivers were so activated. The external drivers necessary to create this input mode consume power when operating to sink the current of the weak pull-ups. The present invention provides a mechanism for disabling the weak pull-ups (in contrast to merely sinking the current of the weak pull-ups) and thereby enables input to the microcontroller with reduced power consumption.

Certain types of microcontrollers (e.g., the 8-bit microcontrollers providing the functions of the 890C32T2 member of the 80C51 family of AMP products) may contain a weak pull-up on certain of the I/O ports of the microcontrollers. As an example of a microcontroller with pull-ups, the 80C51 family of microcontrollers has internal pull-ups on Ports 1, 2 and 3. Port 0 of such microcontrollers, on the other hand, has open-drain outputs. Each I/O line of the microcontroller can be independently used as an input or an output. (Ports 0 and 2 in the 80C51 family may not, generally, be used as general purpose I/O when being used as the ADDR/DATA BUS). To be used as an input, the port bit latch of this example microcontroller must contain a 1, which turns off the fetch/execute timing (FET) mechanism for the output driver. Then, for Ports 1, 2 and 3, the port pin is pulled high voltage by the internal pull-up. When so configured as inputs, these Ports 1, 2 and 3 pull high voltage and will source current when pulled low voltage. Prior to the present invention, if it was desired that the port pin be pulled low voltage so that the pin could serve for input, an external driver creating a sink for the current was necessary. Such an external driver consumes power when driven to create the sink. The present invention eliminates the need for an external driver to overcome the high pull of the pull-ups and thus reduces power consumption thereof by providing a mechanism which selectively disables the weak pull-up so that, in input mode, the port pin is not pulled high thereby. This WPUD method and mechanism is activated by the particular circuitry of the IC.

In a preferred embodiment of the present invention, the weak pull-ups on the Port 1, 2 and 3 I/O lines of a microcontroller, for example, a microcontroller of the previously mentioned 80C51 family, are disabled by setting the corresponding Port Control Register Bits (PCRB) to appropriate values, for example, as shown in the table below:

| PCRB | PORT | BIT FUNCTION |
|------|------|--------------|
| 0 | 0 | Drives a "0" output, no pull-up (80C51 compatible) |
| 0 | 1 | Drives a "1" for 2 cycle, weak pull-up is on. (80C51 compatible) |
| 1 | 0 | Drives a "0" output, no pull-up |
| 1 | 1 | Input only, (no pull-up, high impedance input) |

After RESET, the Port 1, 2 and 3 weak pull-ups are enabled. In an IC containing an emulation mode, preferably the weak pull-ups are disabled and the port pins assume a high impedance state during the emulation mode.

Further in a preferred embodiment, the Port 1, 2 and 3 I/O buffers are capable of disabling the weak p-channel pull-up through software control. The necessity of this function permits the buffers to eliminate current sourcing when the buffer is driven low by an external signal. This weak pull-up disabling feature eliminates undesirable power consumption increases. After reset, all of the Port 1, 2, and 3 I/O buffers are held "high" by the weak pull-up. To disable the weak pull-up, the software must first disable each bit by configuring the port pin with the corresponding port control register bit. The corresponding port control register bit resides at the same address as the port Special Function Register (SFR) bit. For example, Port 1 resides at SFR memory location 90H. The Port 1 control register also resides at SFR memory location 90H. Modification of the Port 1 Control Register is only accomplished when the PCRA bit in the PCFIG SFR is set to a "1". When the PCRA bit is cleared, an operation to the Port SFR address results in the Port SFR getting updated.

Since only Ports 1, 2 and 3 contain weak pull-ups, Port 0 is exempt from this feature.

The WPUD method and mechanism is more fully described and understood when considered with respect to an exemplary microcontroller.

THE EXEMPLARY MICROCONTROLLER

An exemplary microcontroller having weak pull-ups associated with the ports and buffers is the 8051 microcontroller. The 8051 is an 8-bit single-chip microcontroller popularly used in power electronic systems. The 8051 is available in three different versions, 8051 being the generic name. The basic 8051 contains 4-kbytes of ROM, 128-bytes of RAM, two 16-bit timer/counters, four programmable 8-bit I/O ports, serial I/O lines, and two external interrupt lines. It also has an on-chip oscillator and clock circuitry which require an externally connected crystal. The 8031 version of the 8051 does not contain any ROM, and the 8751 version contains an EPROM instead of a ROM. The 8052 version contains 8-kbytes of ROM, 256-bytes of RAM, three timers/counters, and six interrupts (two external). An 8032 version of the 8052 exists which is identical to the latter except that it does not have a ROM.

EP 0 580 337 A2

The CPU of the 8051 family can address up to 64-kbytes of program memory of which the lower 4-kbytes may reside on the chip. The data memory may consist of up to 64-kbytes of off-chip RAM, in addition to including 128 bytes of on-chip RAM. The on-chip RAM contains four register banks (each with eight registers), and 128 addressable bit locations. In addition to data RAM, the 8051 contains a 128-byte SFR which helps the CPU in efficient program execution. The SFR contains arithmetic registers, data and stack pointers and registers as latches for I/O ports. The SFR also contains a 128-bit addressable memory. All the I/O ports are bidirectional and have output drivers and input buffers. All 32 lines of the I/O ports have individual READ/WRITE capabilities. The microcontroller has an 8-bit external data bus, and a 16-bit external address bus. Port O functions as a multiplexed lower order address and data bus during the access to external program and data memory. Data and address signals can be separated by using the address logic enable (ALE) strobe signal. Port 2 functions as a higher order address byte. Ports 1 and 3 can be used as standard I/O. Port 3 has the special functions of serial I/O, external interrupts, timer inputs and READ/WRITE control of external chips.

Now more specifically addressing the port structures and operation of the 8051, as previously stated, all four ports in the 8051 are bidirectional. Each consists of a latch (SFRs P0 through P3), an output driver, and an input buffer.

The output drivers of Ports 0 and 2, and the input buffers of Port 0, are used in accesses to external memory. In this application, Port 0 outputs the low byte of the external memory address, time-multiplexed with the byte being written or read. Port 2 outputs the high byte of the external memory address when the address is 16 bits wide. Otherwise the Port 2 pins continue to emit the P2 SFR content.

All the Port 3 pins, and (in the 8052) two Port 1 pins are multifunctional. They are not only port pins, but also serve the functions of various special features as listed below:

| Port Pin | Alternate Function |
|----------|--------------------|
| *P1.0 | T2 (Timer/Counter 2 external input) |
| *P1.1 | T2EX (Timer/Counter 2 capture/reload trigger) |
| P3.0 | RXD (serial input port) |
| P3.1 | TXD (serial output port) |
| P3.2 | INT0 (external interrupt) |
| P3.3 | INT1 (external interrupt) |
| P3.4 | T0 (Timer/Counter 0 external input |
| P3.5 | T1 (Timer/Counter 1 external input) |
| P3.6 | WR (external Data memory write strobe) |
| P3.7 | RD (external Data memory read strobe) |

*P1.0 and P1.1 serve these alternate functions only on the 8052.

The alternate functions can only be activated if the corresponding bit latch in the port SFR contains a 1. Otherwise the port pin is stuck at 0.

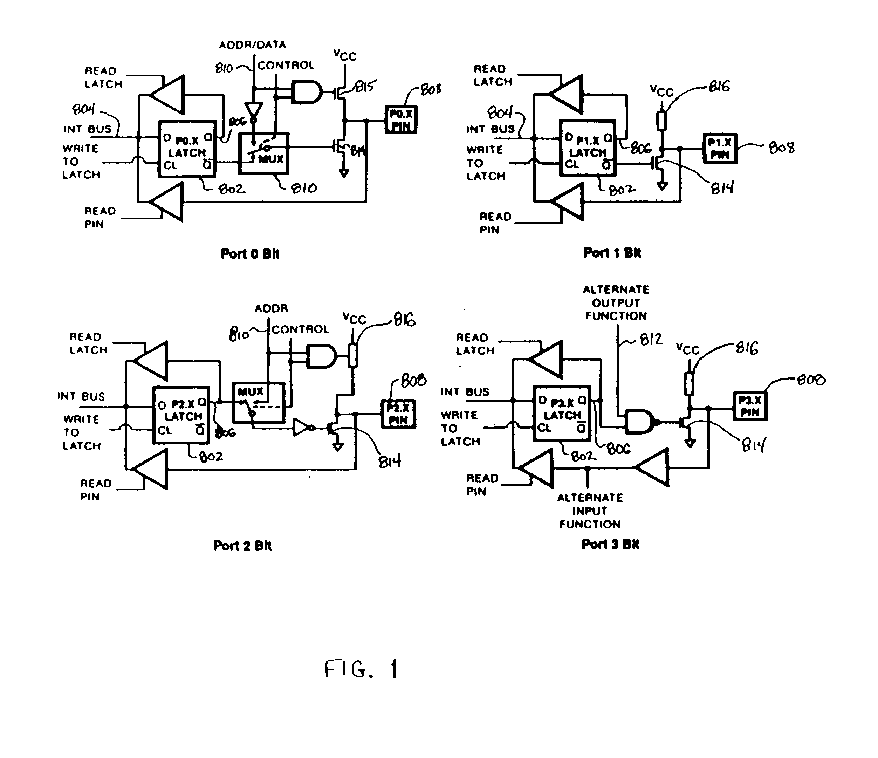

Referring now to the drawings wherein for convenience and clarity like or similar elements are generally referred to with the same reference numeral throughout the several views and initially to FIG. 1, one sees a functional diagram of a typical bit latch and I/O buffer in each of Ports 0, 1, 2 and 3. The bit latch 802 (one bit in the port's SFR) is represented as a Type D flip-flop, which will clock in a value from the internal bus 804 in response to a "write to latch" signal from the CPU. The Q output of the flip-flop is placed on the internal bus 806 in response to a "read latch" signal from the CPU. The level of the port pin 808 itself is placed on the internal bus in response to a "read pin" signal from the CPU. Some instructions that read a port activate the "read latch" signal, and others activate the "read pin" signal.

As shown in FIG. 1, the output drivers (not shown) of Ports 0 and 2 are switchable to an internal ADDR 910 and ADDR/DATA 810 bus by an internal CONTROL signal for use in external memory accesses. During external memory accesses, the P2 SFR remains unchanged, but the P0 SFR gets 1s written to it.

Also shown in FIG. 1, is that if a P3 bit latch contains a 1, then the output level is controlled by the signal labeled "alternate output functions" 812. The actual P3.X pin level is always available to the pin's alternate input function, if any.

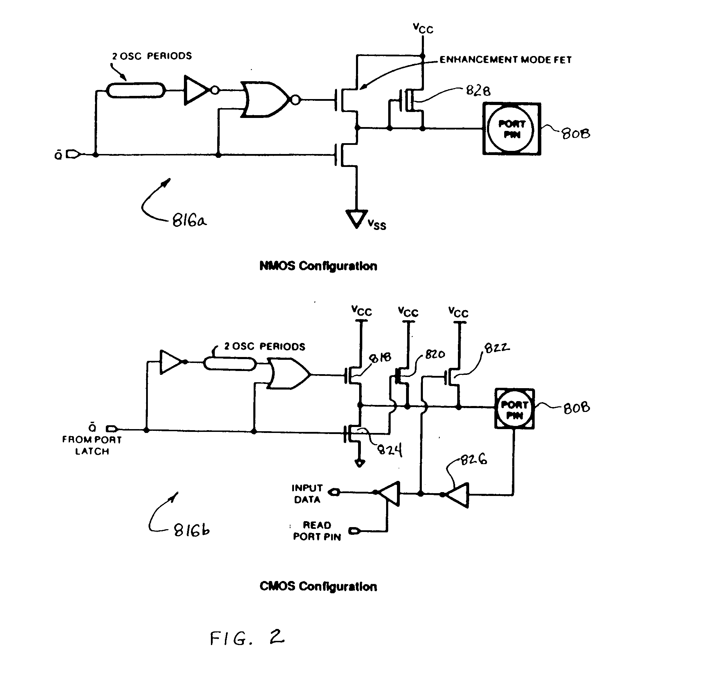

Ports 1, 2 and 3 have internal pull-ups 816 (also shown in detail in FIG. 2). Port 0 has open-drain outputs. Each I/O line can be independently used as an input or an output. (Ports 0 and 2 may not be used as general purpose I/O when being used as the ADDR/DATA BUS.) To be used as an input, the port bit latch must contain a 1, which turns off the output driver FET 814. Then, for Ports 1, 2 and 3, the pin 808 is

7

pulled high by the internal pull-up, but can be pulled low by an external source.

Port 0 differs in not having internal pullups. The pullup FET 814 in the PO output driver is used only when the port is emitting 1s during external memory accesses. Otherwise the pullup FET 814 is off. Consequently P0 lines that are being used as output port lines are open drain. Writing a 1 to the bit latch leaves both output FETs 814, 815 off, so the pin floats. In that condition it can be used as a high-impedance input.

Because Ports 1, 2 and 3 have fixed internal pullups 816, they are sometimes called "quasi-bidirectional" ports. When configured as inputs they pull high and will source current when externally pulled low. Port 0, on the other hand, is considered "true" bidirectional, because when configured as an input it floats.

All the port latches in the 8051 have 1s written to them by the reset function. If a 0 is subsequently written to a port latch, it can be reconfigured as an input by writing a 1 to it.

Concerning writing to a port, in the execution of an instruction that changes the value in a port latch, the new value arrives at the latch during S6P2 of the final cycle of the instruction. However, port latches are in fact sampled by their output buffers only during Phase 1 of any clock period. (During Phase 2 the output buffer holds the value it saw during the previous Phase 1.) Consequently, the new value in the port latch won't actually appear at the output pin until the next Phase 1, which will be at S1P1 of the next machine cycle.

If the change requires a 0-to-1 transition in Port 1, 2 or 3, an additional pull-up is turned on during S1P1 and S1P2 of the cycle in which the transition occurs. This is done to increase the transition speed. The extra pull-up can source about 100 times the current that the normal pull-up can. It should be noted that the internal pull-ups are field-effect transistors, not linear resistors. The pull-up arrangements are shown in detail in FIG. 2.

Referring now to FIG. 2, in NMOS versions of the 8051, the fixed part of the pull-up 816a is a depletion-mode transistor with the gate wired to the source. This transistor will allow the pin 808 to source about 0.25 mA when shorted to ground. In parallel with the fixed pull-up is an enhancement-mode transistor, which is activated during S1 whenever the port bit does a 0-to-1 transition. During this interval, if the port pin 808 is shorted to ground, this extra transistor will allow the pin 808 to source an additional 30 mA.

In the CMOS versions, the pull-up 816b consists of three p-channel FETs (pFET) 818, 820, 822. It should be noted that an n-channel FET (nFET) 824 is turned on when logical 1 is applied to its gate, and is turned off when a logical 0 is applied to its gate. A pFET is the opposite: it is on when its gate sees a 0, and off when its gate sees a 1.

Transistor pFET 1 818 in FIG. 2 is turned on for two oscillator periods after a 0-to-1 transition in the port latch. While it's on, it turns on pFET 3 822 (a weak pull-up) through the inverter 826. This inverter 826 and pFET 3 822 form a latch which holds the 1.

Note that if the pin 808 is emitting a 1, a negative glitch on the pin 808 from some external source can turn off pFET 3 822, causing the pin 808 to go into a float state; pFET 2 820 is a very weak pull-up which is on whenever the nFET 824 is off, in traditional CMOS style. It's only about 1/10 the strength of pFET 3 822. Its function is to restore a 1 to the pin 808 in the event the pin 808 had a 1 and lost it to a glitch.

Regarding port loading and interfacing, the output buffers of Ports 1, 2 and 3 can each drive four LS TTL inputs. The ports on NMOS versions can be driven in a normal manner by any TTL or NMOS circuit. Both NMOS and CMOS pins 808 can be driven by open-collector and open-drain outputs, but note that 0-to-1 transitions will not be fast. In the NMOS device 816a, if the pin 808 is driven by an open-collector output, a 0-to-1 transition will have to be driven by the relatively weak depletion mode FET 828 in FIG. 2. In the CMOS device, an input 0 turns off pull-up pFET3 822, leaving only the very weak pull-up pFET2 820 to drive the transition.

Referring back to FIG. 1, Port 0 output buffers can each drive 8 LS TTL inputs. They do, however, require external pull-ups to drive NMOS inputs, except when being used as the ADDRESS/DATA bus.

Boolean processing capability is a special feature of the 8051 microcontroller. In this function, the microcontroller processes bit signals with its own instruction set, its own accumulator and bit addressable internal data RAM and SFR. The 8051 has five hardware activated interrupts, two of which are external. The internal interrupts are generated by timers and the internal serial port. The priority level of interrupts can be predefined. The interrupts can be selectively or globally disabled. The internal timer/counters can be used for measuring pulse widths and time internals, counting events, and causing periodic interrupts. Each counter can be operated in a number of modes.

The 8051 software program can be written in assembly language using an instruction set consisting of 111 instructions. The instructions are divided into functional groups: arithmetic operations, logic operations, data transfer, Boolean variable manipulation, and program machine control. For non-time-critical applications the microcontroller is supported by PL/M language.

## THE EXEMPLARY IC

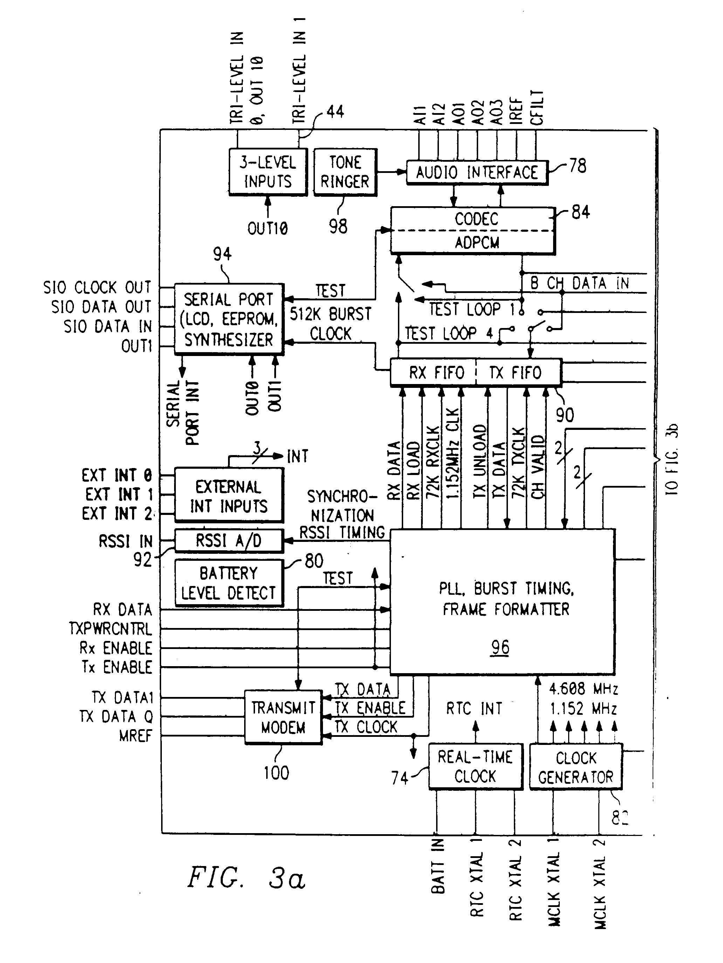

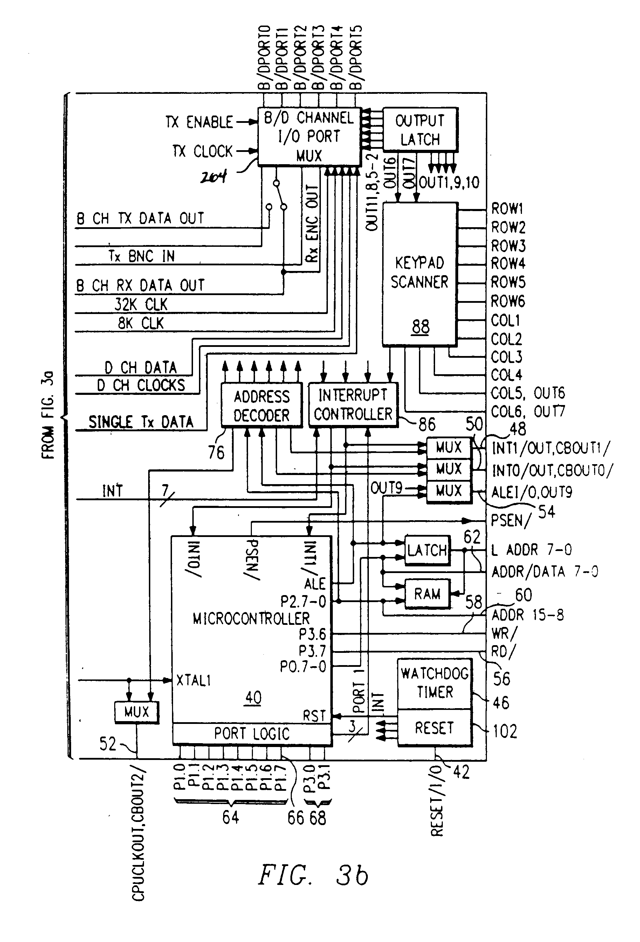

Referring now to FIG. 3 (which consists of FIGS. 3a and 3b), there is shown a block diagram of an exemplary IC which incorporates a WPUD method and mechanism according to the teachings of the present invention. Pertinent elements of the exemplary IC with respect to the WPUD method and mechanism thereof will be discussed hereinbelow. The exemplary IC includes an 8-bit microcontroller providing the function of the 8OC32T2 member of the 8OC51 family of AMD products, as previously described and as more particularly described herein to the extent as may be relevant to the particular embodiment of the WPUD method and mechanism incorporated in the exemplary IC.

## SYSTEM CONTROL -- REQUIREMENTS

Certain aspects of the IC system control relevant to the WPUD method and mechanism are described hereinbelow. For further details than those given herein of system control requirements and other system matters of the IC, reference may be had to the various related applications.

In the exemplary IC shown in FIG. 3 (which IC, as previously stated, is exemplary of the type IC in which the WPUD method and mechanism of the present invention may be incorporated), the PSEN/pin assumes a high impedance state when the in-circuit emulation capability mode of the IC is triggered.

As part of a functional view of the system control, it is appropriate now to discuss I/O port utilization and effects thereon of the WPUD method and mechanism. Accordingly, each of the four I/O ports used in the exemplary IC in which the present invention may be included is discussed immediately below.

With regard to Port O, it is used in connection with multiplexed address/data bus bits 7-0.

Port 1 is used for general I/O lines. These lines are mapped to specific control functions by software. The Port 1 I/O lines contain a weak pull-up. Disabling the weak pull-up is accomplished by setting the corresponding PCRB to an appropriate value (as described below). During emulation mode, the weak pull-ups are disabled and the port pins assume a high impedance state.

Port 2 is used for address lines 15-18. The Port 2 I/O lines contain a weak pull-up. Disabling the weak pull-up is accomplished by setting a corresponding PCRB to an appropriate value (as described below). After RESET, the Port 2 weak pull-ups are enabled. During emulation mode, the weak pull-ups are disabled and the port pins assume a high impedance state.

With regard now to Port 3, P3.0, P3.1, P3.2, P3.3, P3.4, P3.5, P3.6, and P3.7 need to be discussed.

P3.0 is used as either the microcontroller serial port receive data input (RxD) or as a general purpose I/O pin. P3.1 is used as either the microcontroller serial port transmit data output (TxD) or as a general purpose I/O pin. P3.2 is used internally as an interrupt input from the internal interrupt controller (INTO/). P3.3 is used internally as an interrupt input from the internal interrupt controller (INT1/). P3.4 is used as the internal timer 0 clock input. This pin is not available external to the IC. P3.5 is used as the internal timer 1 clock input. This pin is not available external to the IC. P3.6 is the WR/ strobe for the address/data bus. P3.7 is the RD/ strobe for the address/data bus. The Port 3 I/O lines contain a weak pull-up. Disabling the weak pull-up is accomplished by setting a corresponding PCRB to an appropriate value (as described below). After RESET, the Port 3 weak pull-ups are enabled. During emulation mode, the weak pull-ups are disabled and the port pins assume a high impedance state.

Discussing now I/O buffer configuration, in the exemplary IC in which an embodiment of the present invention may be incorporated, the Port 1, 2, and 3 I/O buffers are capable of disabling the weak p-channel pull-up through software control. The necessity of this function permits the buffers to eliminate current sourcing when the buffer is driven low by an external signal. This weak pull-up disabling feature of the exemplary IC eliminates undesirable power consumption increases. The AND 80C32T2 lacks such a mechanism. After reset, all of the Port 1, 2, and 3 I/O buffers are held "high" by the weak pull-up. This state is functionally compatible with the 80C32T2 microcontroller. To disable the weak pull-up, the software must first disable each bit by configuring the port pin with the corresponding port control register bit. The corresponding port control register bit resides at the same address as the port SFR bit. For example, Port 1 resides at SFR memory location 90H. The Port 1 control register also resides at SFR memory location 90H. Modification of the Port 1 Control Register is only accomplished when the PCRA bit in the PCFIG SFR is set to a "1". When the PCRA bit is cleared, an operation to the Port SFR address results in the Port SFR getting updated.

Since only Ports 1, 2 and 3 contain weak pull-ups, Port 0 is exempt from this feature.

The following table describes the different combinations of the port setup in the exemplary IC.

| PCRB | PORT | BIT FUNCTION |
|---|---|---|
| 0 | 0 | Drives a "0" output, no pull-up (80C51 compatible) |
| 0 | 1 | Drives a "1" for 2 cycle, weak pull-up is on. (80C51 compatible) |
| 1 | 0 | Drives a "0" output, no pull-up |
| 1 | 1 | Input only, (no pull-up, high impedance input) |

Upon power-up, the PCRA bit is disabled and any writes to the ports result in the port SFR being updated. Once the PCRA bit in the PCFIG register is set, it becomes possible for each port bit to have the weak p-channel device turned off. After each port bit is appropriately configured, the user must clear the PCRA bit before writing to the ports.

If the user turns on the weak p-channel device after it is disabled, the port pin may not return to a "1" immediately. This condition is similar to the 80C51 when an external device drives the input signal low and then allows the pin to "float" back to a "1". This rise time of the signal is dependent on the loading of the pin and may take several microseconds to return to a stable "1".

Discussing now SFR map additions in the exemplary IC, the following additions are made to the SFR map to disable the weak pull-ups on the microcontroller pins:

| SFR NAME | SFR ADDRESS | SFR AFTER RESET |
|---|---|---|
| PCFIG | A1H | 00H |
| P1PCRB* | 90H* | 00H |
| P2PCRB* | A0H* | 00H |
| P3PCRB* | B0H* | 00H |

\* These ports registers are only accessible when the PCRA bit in the PCFIG register is set to a "1".

SFR NAME

PCFIG   Address:  A1H Reset Value:   OOH

| 0 | 0 | 0 | 0 | 0 | 0 | 0 | PCRA |
|---|---|---|---|---|---|---|---|

PCFIG contains PCRA, a bit that permits access to the PCRB when accessing a port address.

P1PCRB   Address: 90H* Reset Value: OOH* Only accessible when PCRA=1

| P1.7CB | P1.6CB | P1.5CB | P1.4CB | P1.3CB | P1.2 CB | P1.1 CB | P1.0CB |
|---|---|---|---|---|---|---|---|

P1.7CB-P1.OCB: Corresponding Port Control Bits for P1.7-P1.0

P2PCRB Address: AOH* Reset Value: OOH* Only accessible when PCRA=1

| P2.7CB | P2.6CB | P2.5CB | P2.4CB | P2.3CB | P2.2 CB | P2.1 CB | P2.0CB |
|--------|--------|--------|--------|--------|---------|---------|--------|

P2.7CB-P2.0CB: Corresponding Port Control Bits for P2.7-P2.0

P3PCRB Address: BOH* Reset Value: OOH* Only accessible when PCRA=1

| P3.7CB | P3.6CB | P3.5CB | P3.4CB | P3.3CB | P3.2 CB | P3.1 CB | P3.0CB |
|--------|--------|--------|--------|--------|---------|---------|--------|

P3.7CB-P3.0CB: Corresponding Port Control Bits for P3.7-P3.0

Discussing now the interface to on-chip peripheral bus in the exemplary IC presented as an example of the type of IC in which the present invention may be incorporated, all user visible registers and on-chip RAM reside on an internal version of the microcontroller address/data bus. In order to reduce power consumption, this bus does not change state during accesses to program memory space. When the IC is in emulation mode, this power saving feature is not available, and the on-chip peripheral bus will transition during accesses to program memory space.

Discussing now on-chip RAM in the exemplary IC, such an IC having an 80C32T2 microcontroller has 256 bytes of RAM located in the "Internal Data RAM" space. 1024 bytes of additional "on-chip" RAM is located in "External Data RAM" space. All of the 1024 bytes of on-chip RAM is backed up by the real-time clock's back-up battery. The backed up RAM can support read and write accesses down to 2.2 Volts. The backed up RAM can retain data down to 1.8 Volts.

Discussing now interrupt enable during shut-down in the exemplary IC, if the IC is in a shut-down mode and the microcontroller is in an idle mode, the condition of the microcontroller's interrupt mask bits (TCON register bits 7, 2, and 0) is ignored, enabling the INT0/ and INT1/ interrupts. The actual TCON bits are not changed to safeguard against the IC entering a shut-down mode with interrupts disabled.

It should also be noted that in the exemplary IC, anytime that the CPUCLK speed is programmed to be less than 9.216 Mhz the length of the PSEN pulse is shortened by one cycle of CPUCLK (that is, the falling edge is delayed by one CPUCLK cycle). This reduces the power consumed by the external memory devices when the CPUCLK is slowed down.

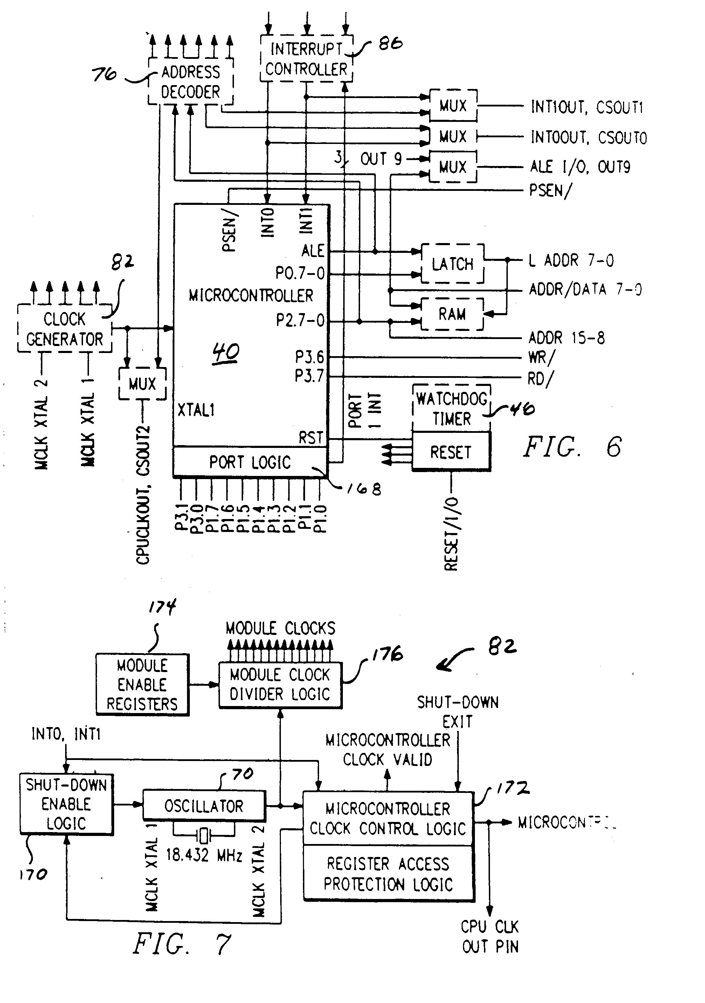

Those skilled in the art should take note with reference to FIG. 6 that the ALE I/O pin is multiplexed with the general output bit 9. The INT0/OUT and INT1/OUT pins are multiplexed with the external I/O 0 and external RAM chip select outputs, respectively, from the address decoder module 76. During the in-circuit emulation mode, these pins always provide the ALE-OUT, INT0/, and INT1/OUTPUT functions. During normal operation, the ALE pin can be either ALE OUT or general output 9. Selection is programmed in the address decoder module. The INT0/ and INT1/ pins are always used as chip select outputs in normal operation.

Those skilled in the art should take further note with reference to FIG. 6 that a demultiplexed form of the 80C32T2's address bus is constructed by latching the low-order address byte, providing the LATCHED ADDRESS 7-0 pins. The address is latched off of the A/D 7-0 bus on the falling edge of ALE. In the exemplary IC, internal timing accounts for the delays associated with bringing A/D 7-0 and ALE on chip when the exemplary IC is in in-circuit emulation mode.

To facilitate a complete understanding of the microcontroller shown in FIG. 6 and its role in the IC of the exemplary IC which includes the WPUD method and mechanism of the present invention, a brief discussion of each pin shown therein follows.

PO.7-PO.0 is the microcontroller I/O port 0. This port provides the multiplexed D7-0 and A7-0 bus. When the exemplary IC is in reset the pins are held weakly high. In shut-down, the pins will either be held strongly low or weakly high. In in-circuit emulation mode the pins are high impedance.

11

P1.7-P1.0 is the microcontroller I/O port 1. This port provides the eight general purpose I/O pins associated with the parallel port module. When the IC is in reset the pins are held weakly high. In shut-down, the pins hold their programmed state. In in-circuit emulation mode the pins are high impedance.

P2.7-P2.0 is the microcontroller I/O port 2. This port provides the high order eight bits of the address bus (A15-8). When the IC is in reset or shut-down, the pins are held weakly high. In in-circuit emulation mode the pins are high impedance.

P3.7 is the microcontroller I/O port 3.7. This pin provides the microcontroller RD/ (read, active low) strobe. In in-circuit emulation mode the pin is high impedance. In shut-down or during reset the pin is held weakly high.

P3.6 is the microcontroller I/O port 3.6. This pin provides the microcontroller WR/ (write, active low) strobe. In in-circuit emulation mode the pin is high impedance. In shut-down or during reset the pin is held weakly high.

P3.1 is the microcontroller I/O port 3.1. This pin provides the microcontroller's internal serial port transmit data output. The pin can also be used as a general purpose I/O port. In in-circuit emulation mode the pin is high impedance. In reset the pin is held weakly high. In shut-down the pin holds its programmed state.

P3.0 is the microcontroller I/O port 3.0. This pin provides the microcontroller's interpal serial port receive data input. The pin can also be used as a general purpose I/O port. In in-circuit emulation mode the pin is high impedance. In reset the pin is held weakly high. In shut-down the pin holds its programmed state.

PSEN/ is the program store enable. When active, the address on ports 0 and 2 pertains to code space. PSEN/ is placed in a high impedance state in in-circuit emulation mode, and is an output in normal mode. In reset, PSEN/ is held weakly high. In shut-down the pin is held strongly high.

ALE is the address latch enable. This signal is used to latch the address off of the A/D 7-0 bus. ALE is high impedance during in-circuit emulation mode. ALE is an output, multiplexed with OUT9 during normal mode. In shut-down or reset the pin is held strongly high.

LATCHED ADDRESS 7-0 is the output of the address latch, providing the non-multiplexed LA7-0 bus. At reset, shut-down, and in in-circuit emulation mode these pins are driven strongly.

## SYSTEM CONTROL -- CLOCK GENERATOR

The clock generator 82 (see FIG. 3a) provides the crystal oscillator, power mode control, module enable control, and clock dividers for the exemplary IC.

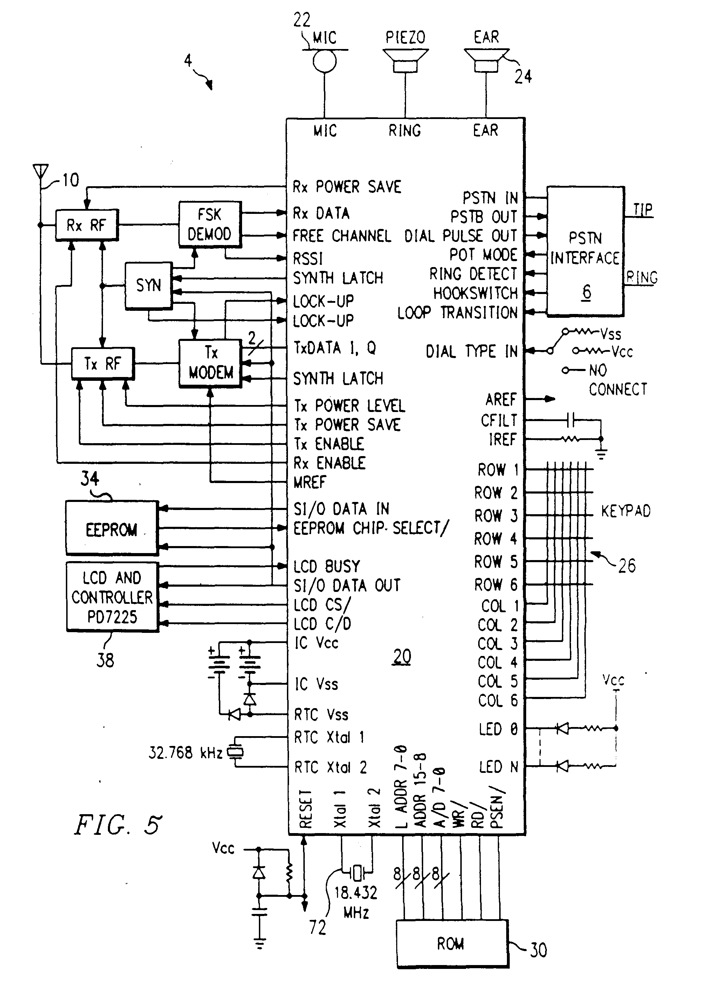

When the IC is placed in shut-down mode the 18.432 Mhz oscillator (e.g., oscillator 72 in FIG. 5) and all clocks derived from it are stopped. All modules are disabled except the real-time clock 74. All analog pins are placed in their off state, that is, the same state as when the IC is in reset.

The IC is placed into shut-down mode by setting a bit in a shut-down/microcontroller clock control register. After the bit is set the oscillator 72 continues to run for 3.56 - 7.12 milliseconds in order for software to place itself in its idle mode, then all clocks, including the CPUCLK are stopped. In the exemplary IC, the IC terminates the shut-down cycle if an interrupt is received after the enable bit is set, and before the CPU clock is stopped.

Continuing to discuss the exemplary IC, access to the shut-down/microcontroller clock control register is protected by an interlock mechanism to reduce the risk of accidental clock stoppage due to software problems. This mechanism requires the software to write to a special access control register, and then write the shut-down/microcontroller clock control register. This double-write procedure must be done twice before the clock speed control register is updated.

Wake-up comes from reset, an any-key-down indication from the keypad scanner 88, the real-time clock interrupt (if not masked within the real-time clock 74), or any non-masked interrupt. When the IC leaves shut-down mode the oscillator is re-started. A delay of approximately 3.56 milliseconds is required for the oscillator to stabilize. After this delay, the microcontroller 44 and watchdog timer 46 clocks are re-started. The microcontroller clock re-starts at the previously programmed rate.

When the IC is in shut-down, the keypad any-key-down and real-time clock interrupts are enabled, even if the associated interrupt enable bits are cleared, i.e., even if the interrupts are disabled. The actual interrupt enable bits are not changed. Also, it should be noted that the real-time clock interrupts can still be masked within the real-time clock module 74 in the exemplary IC.

The microcontroller clock in the exemplary IC has a programmable divider with an input of 18.432 Mhz. The programmable rates are divided by 2, 4, 8, 16, 32, 64, 128, and 256. When the IC leaves the shut-down mode, the CPU clock returns to the speed programmed in the control register. The CPUCLK can be turned

EP 0 580 337 A2

off by placing the IC in shut-down mode.

When the clock speed is changed, the transition to the new frequency is accomplished without producing clock pulses that violate the 80C32T2, or other such appropriate product, data sheet timing specifications.

The microcontroller clock also has a selectable automatic speed-up mode. If the automatic speed-up option is selected, all interrupts force the microcontroller clock divider to the divide by two state. After the clock is sped-up, it will remain at the divided by two frequency until the speed is reprogrammed to a lower value. No illegally short pulses are allowed at the frequency transition point.

Once the command is issued by the microcontroller to enter shut-down, the processor clock continues to run for between 3.56 and 7.12 milliseconds before being stopped.

The clocks to each module are provided by the clock generator module 82. Control bits are provided to allow software to turn on and off specific modules. When a module is turned off, its clock is stopped and held low.

The serial port 94 supports data rates of 288 kHz, 144 kHz, and 36 kHz. The clock provided to the serial port module is divided down to the desired data rate by the clock generator module 82. The clock speed is selected via the serial port timing control register. The serial port module and this clock are enabled via a module enable control register 0. When the module is disabled, the clock is stopped low.

FIG. 7 is a block diagram of the clock generator module of the exemplary IC. As may be seen in FIG. 5, the clock generator module directly or indirectly comprises the oscillator 70, shut-down mode control logic 170, microcontroller clock control logic 172, module enables 174, and a module clock divider 176. Each of these is described further in an individual paragraph immediately below.

The oscillator 70 is designed to run at 18.432 MHz, using a parallel resonant mode crystal. Start-up capacitors are required; however, the exemplary IC minimizes capacitance value to save power.

The shut-down mode/microcontroller clock control logic 170, 172 controls the entry into shut-down, microcontroller clock frequency, and automatic speed-up.

With respect to the module enables 174, register bits to turn on and off specific modules within the IC are located in the clock generator module 82. These bits also stop the clock outputs to their respective modules.

The module clock divider logic 176 is a divider chain that produces the clock frequencies required by each module.

The clock generator module 82 has three pins. Pin MCLK XTAL is the master clock crystal pin 1. This pin is for input and is on the input side of the oscillator 70. The oscillator 70 is designed to work with either a parallel resonant crystal or an external logic level input. The MCLK XTAL 2 pin is the master clock crystal pin 2. This pin is for output and is on the output side of the oscillator 70. If a crystal is used, this pin is connected to the crystal. If an external logic level signal is used, this pin is left unconnected. The CPUCLKOUT pin is connected to the same clock that feeds the microcontroller 40. It is an output that can be routed off chip. In in-circuit emulation mode, the CPUCLKOUT is always active. When the IC is not in in-circuit emulation mode, this clock is multiplexed with the CSOUT2/ signal from the parallel I/O port module. The multiplexer control is located in the address decoder module 76 (see FIG. 3b). In reset, this pin defaults to the CSOUT2/ function, and is held high. At shut-down, if the pin is programmed for CPUCLK operation it is held low.

The clock controller module 82 of the exemplary IC contains the following programmable registers: a shut-down/microcontroller clock control register; a shut-down/microcontroller clock access; a protection register; a module enable control register 1; a module enable control register 2; and a serial port timing control register.

SYSTEM CONTROL--ADDRESS DECODER

The addresses of all internal registers as well as the on-chip RAM and the three external chip selects of the exemplary IC are decoded by the address decoder module 76. Enable signals are generated when internal registers or internal RAM is accessed by the microcontroller. Chip selects outputs are generated when external RAM space or either of the two external I/O spaces are accessed.

The address decoder module 76 of the exemplary IC includes a CSOUT0/pin, a CSOUT1/pin and a CSOUT2/pin. The CSOUT0/pin carries a signal which is multiplexed with the INT0/OUT signal. This pin also provides the chip select function when the IC is not in in-circuit emulation mode. The CSOUT0/signal is active (low) when a MOVX instruction is executed to the external I/O 1 space. In reset or shut-down this pin is held high. The CSOUT1/pin carries a signal which is multiplexed with the INT1/OUT signal. This pin also provides the chip select function when the IC is not in in-circuit emulation mode. The CSOUT1/ signal is

13

active (low) when a MOVX instruction is executed to the external RAM space. In reset or shut-down this pin is held high. The CSOUT2/pin carries a signal which is multiplexed with the CPUCLKOUT signal. This pin also provides the chip select function when the IC is not in in-circuit emulation mode and the CSOUT2/ enable bit is set in a chip select control register. The CSOUT2/ signal is active (low) when a MOVX instruction is executed to the external I/O 2 space. In reset, this pin is head high. If the pin is programmed for CSOUT2/ mode, it is held high in shut-down.

The aforementioned chip select control register is the only user visible register in the address decoder module 76.

It may also be noted that the decoder module 76 of the exemplary IC includes an address latch and an associated pin. The address latch provides the latched form of the low order eight address bits (LADDR 7-0). The latched address bus (LADDR 7-0) pins are outputs when the IC is in normal, shut-down, or in-circuit emulation modes. When the IC is in shut-down, the pins are driven strongly with the last value before entering shut-down. The outputs change on the falling edge of ALE.

## SYSTEM CONTROL--INTERRUPT CONTROLLER

The interrupt controller 86 of the exemplary IC gathers interrupt requests from various sources internal and external to the IC and generates an interrupt to the microcontroller 40 (INT0/ and INT1/).

The interrupt system employed in the exemplary IC in which an embodiment of the WPUD method and mechanism of the present invention may be incorporated has a multilevel structure, including interrupt causes and status registers, a local mask, a local interrupt source register, a main interrupt mask register, and a main interrupt source register. Each of these elements is discussed further in an individual paragraph immediately below.

With regard to interrupt causes and status registers, the causes of the interrupts form the lowest level, and are local to each module. These causes can be inputs to pins, conditions such as empty or full data buffers, and the like. The causes are reported in "status registers". A status register, when read by software, always returns the current state of cause signal (for example, the current logic level on an input pin). The bits in a status register are not affected by interrupt masking.

Discussing now the local mask, the cause signals are ANDed with associated mask signals from an "interrupt mask register". The output of these AND gates connect to a "local interrupt source register". The mask register is located in the module that contains the associated cause signals.

The local interrupt source register is used by software to determine the cause of an interrupt. The bits in the interrupt source register can be set by either rising edge, falling edge, or both edges of the non-masked cause signal. The bits in interrupt source registers are cleared separately from each other. In general, each bit is cleared when software responds to the cause. This response can be reading a receive buffer, reading an input port status register, or the like. The outputs of each of the register bits is ORed together to produce one interrupt request signal. This signal is sent to the interrupt controller module. The source register is located in the module that contains the associated cause signals.

With respect to the main interrupt mask register, the interrupt request signals are ANDed with associated mask signals from the "main interrupt mask register" (located in the interrupt controller module 86). The output of these AND gates connect to a "main local interrupt source register".

The main interrupt source register is used by software to determine the cause of an interrupt. The bits in the interrupt source register reflect the logic level of the interrupt request signals, provided they are not masked. In general, each interrupt request is cleared when software responds to the specific interrupt cause. The outputs of the main interrupt source register are ORed together and forwarded to the microcontroller.

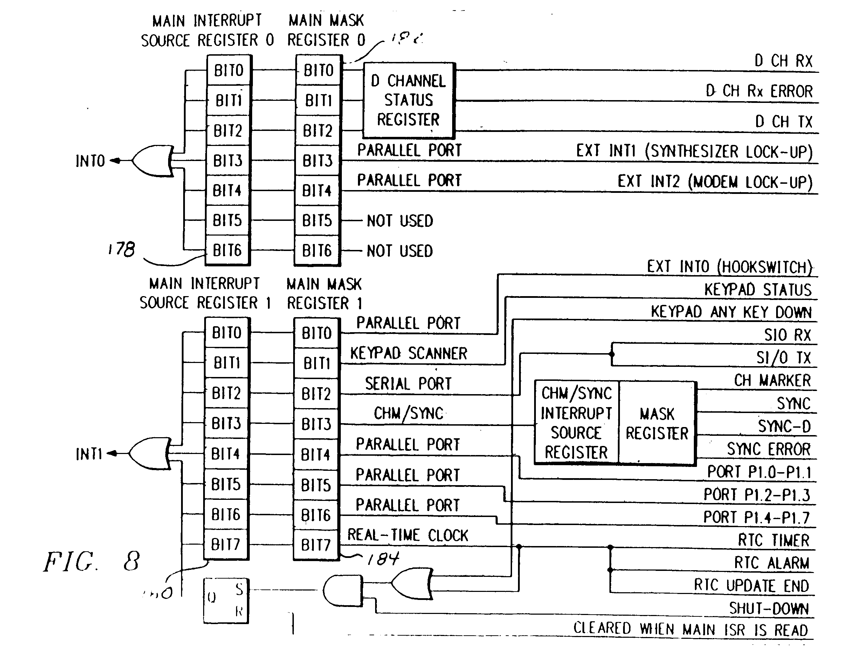

Figure 8 shows the structure of the interrupt controller 86 of the exemplary IC. Interrupt requests from the logic module 96 (see FIG. 1a), external interrupt inputs (such as hookswitch/lock-ups), the serial I/O 94, the parallel I/O (see FIG. 13 and the accompanying discussion), keypad scanner 88, and the real-time clock 74 modules feed the two main interrupt source registers 178, 180. A master interrupt mask function is provided in the microcontroller in the form of a main mask register 0 182, and a main mask register 1 184.

By way of example only, set forth immediately below is a list of interrupt causes in the exemplary IC employed in a cordless telephone application.

| INTERRUPT CAUSE | SET/CLEARED |
|---|---|
| D channel receive | SET:  Receive buffer contains 6 bytes of data<br>CLEARED:  When receive buffer is read |

| | |
|---|---|
| D channel receive error | SET:  Error detected in received D channel data<br>CLEARED:  D Channel Status Register is read |
| D channel transmit | SET:  Transmit buffer empty<br>CLEARED: When transmit buffer is loaded |
| SI/O receive | SET:  Receive buffer full<br>CLEARED: Reading receive buffer |
| SI/O transmit | SET:  Transmit buffer empty<br>CLEARED: When transmit buffer is loaded |
| RTC timer | SET:  Timer bit set (and not masked)in RTC Source Register<br>CLEARED:  Reading RTC Source Register |
| RTC alarm | SET:  Alarm bit set (and not masked)in RTC Source Register<br>CLEARED:  Reading RTC Source Register |
| RTC update end | SET:  Update end bit set (and not masked) in RTC Source Register<br>CLEARED:  Reading RTC Source Register |

| | |
|---|---|
| PI/O P1.0-P1.1 | SET:  Programmed edge of non-masked port 1 pin<br>CLEARED:  Reading PI/O Interrupt Source Register 0 |
| PI/O P1.2-P1.3 | SET:  Programmed edge of non-masked port 1 pin<br>CLEARED:  Reading PI/O Interrupt Source Register 1 |
| PI/O P1.4-P1.7 | SET:  Programmed edge of non-masked port 1 pin<br>CLEARED:  Reading PI/O Interrupt Source Register 2 |
| Keypad status | SET:  Change in Keypad Status Register<br>CLEARED:  Reading Keypad Status Register |
| Keypad any key down | SET:  Key closure when IC is in shut-down mode<br>CLEARED:  Reading Main Interrupt Source Register 1 |
| External interrupt inputs 1, 2, and 3 | SET:  Any transition of the external interrupt input pins (normally used for hookswitch, synthesizer lockup, and modulator lock-up<br>CLEARED:  Reading the indicated External Interrupt Status Register (one register for each input) |

| CHM | SET: Rising edge of CHM signal<br>CLEARED: Reading CHM/Sync Source Register |
| SYNC | SET: Rising edge of sync signal<br>CLEARED: Reading CHM/Sync Source Register |
| SYNC-D | SET: Rising edge of sync-D signal<br>CLEARED: Reading CHM/Sync Source Register |
| Sync error | SET: Rising edge of sync error signal<br>CLEARED: Reading CHM/Sync Source Register |

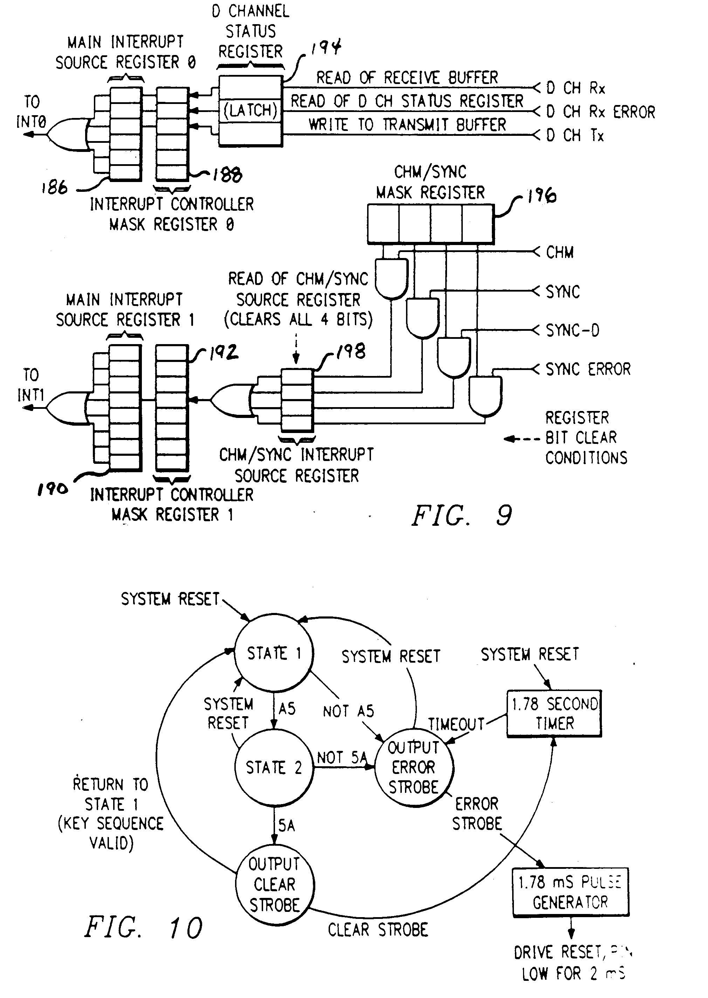

FIG. 9 shows the structure of the status, mask, and source registers necessary to handle interrupt cause signals from the logic module 96.

The interrupt controller module 86 of the exemplary IC is comprised of seven user-accessible registers: a main interrupt source register 0 186; a main interrupt mask register 0 188; a main interrupt source register 1 190; a main interrupt mask register 1 192; a D-channel status register 194; a CHM/SYNC mask register 196; and a CHM/SYNC interrupt source register 198.

The interrupt controller 86 includes an INT0/OUT pin, and an INT1/OUT pin. The INT0/OUT signal is an output from the interrupt controller 86 to the microcontroller 40. It is routed off-chip via the INT0/OUT pins. It is used only in in-circuit emulation mode. When the IC is not in in-circuit emulation mode, this pin is used for the chip select zero (CSOUT0) output. The INT1/OUT pin carries a signal which is an output from the interrupt controller 86 to the microcontroller 40. It is routed off-chip via the INT1/OUT pin. It is used only in in-circuit emulation mode. When the IC is not in in-circuit emulation mode, this pin is used for the chip select one (CSOUT1) output.

User accessible registers in the interrupt controller module include the main interrupt source register 0 186; the main interrupt source register 1 190; the main interrupt mask register 0 188; the main interrupt mask register 1 192; the D channel status register; the CHM/Sync interrupt source register 198; and the CHM/Sync mask register 196.

SYSTEM CONTROL--WATCHDOG TIMER/RESET

The watchdog timer 46 of the exemplary IC detects if the microcontroller software becomes hung-up or lost, and generates a hardware reset to the IC as well as the rest of the system. A hardware reset is generated if an internal counter is not cleared every two seconds. The counter is cleared by the microcontroller 40 writing a specific code sequence to an internal watchdog key register. It should be noted that the watchdog timer 46 is not operational in shut-down or in-circuit emulation modes.

FIG. 10 is a state diagram of the watchdog timer and the reset output mechanism.

The watchdog timer 46 of the exemplary IC generates a 1.78 ms pulse on the RESET/ (active low) pin if it times out. Hardware internal to the IC is also reset by a watchdog timer time-out; the result is identical to activating the RESET/pin. The time-out value is approximately 1.78 seconds. A specific key sequence must

EP 0 580 337 A2

be written to the aforementioned internal watchdog key register within this 1.78 seconds after reset, and within 1.78 seconds of the previous update, to prevent time-out.

The key sequence is a two stage function starting from reset. The watchdog timer 46 starts in stage one, waiting for a write to the watchdog key register. If the value written to the watchdog key register is anything but an A5H, a system reset is generated (just as if the terminal count had been reached). If the write was an A5H, stage two is entered. In stage two, the watchdog timer 46 waits for another write. If the write is a 5AH, the timer is reset and stage one is re-entered. If the write is something other than a 5AH, a system reset is generated.

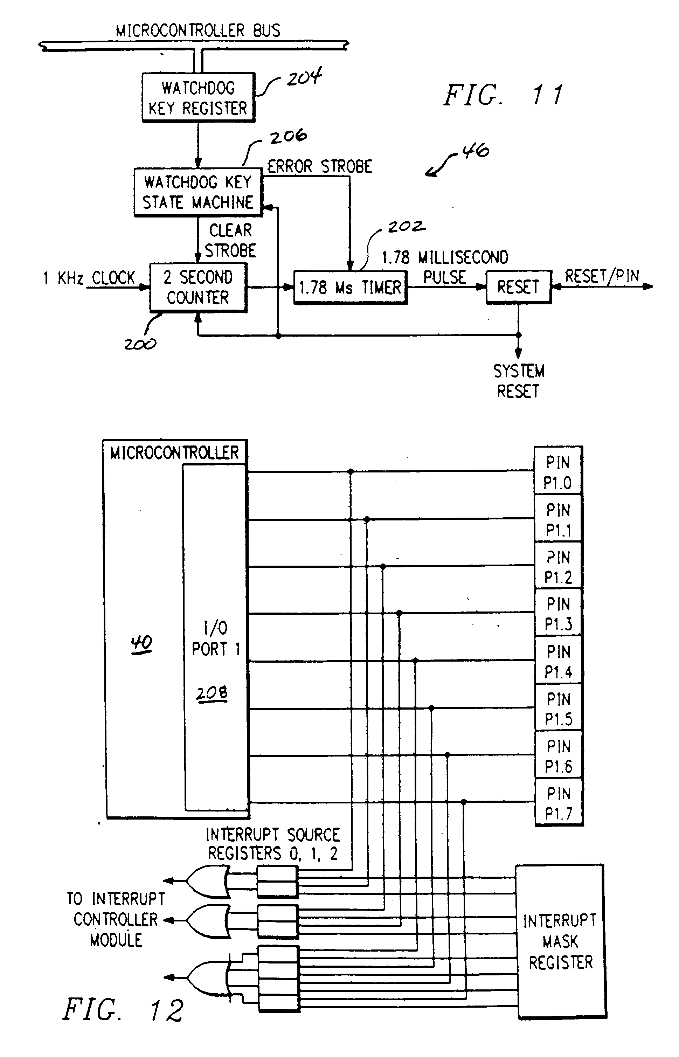

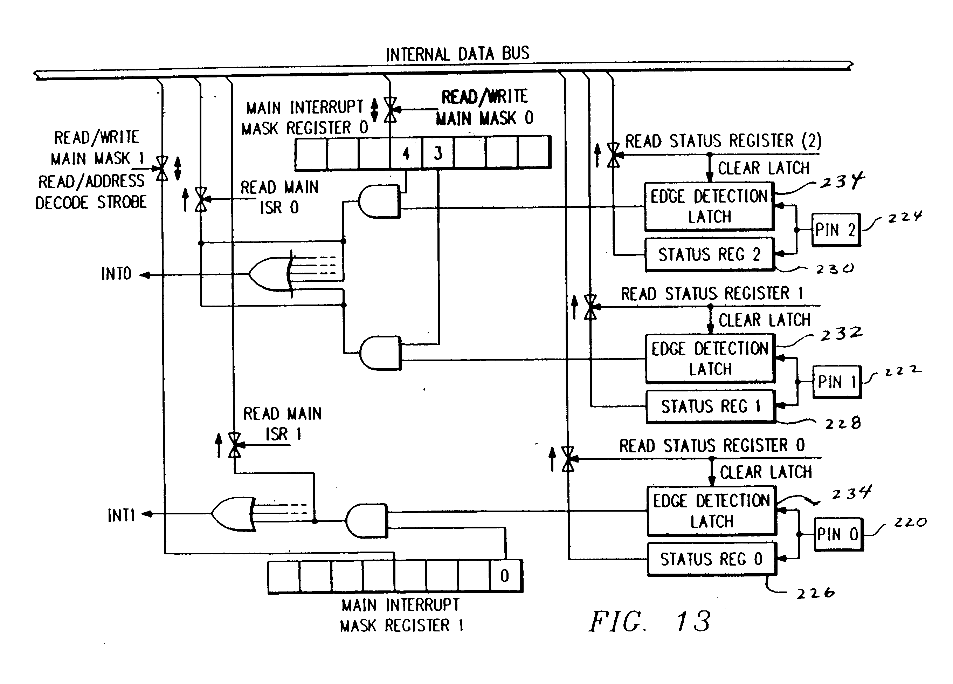

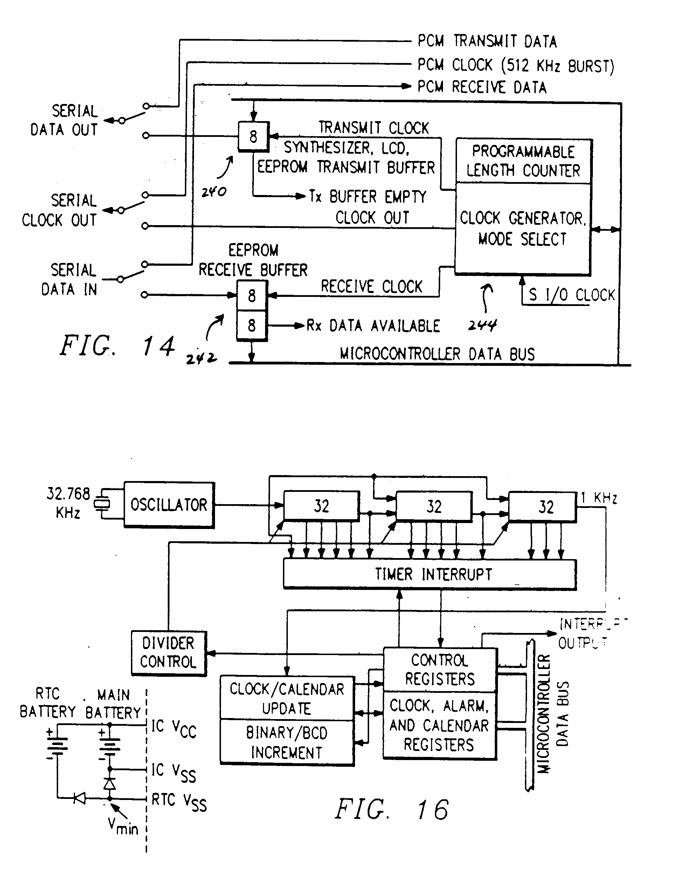

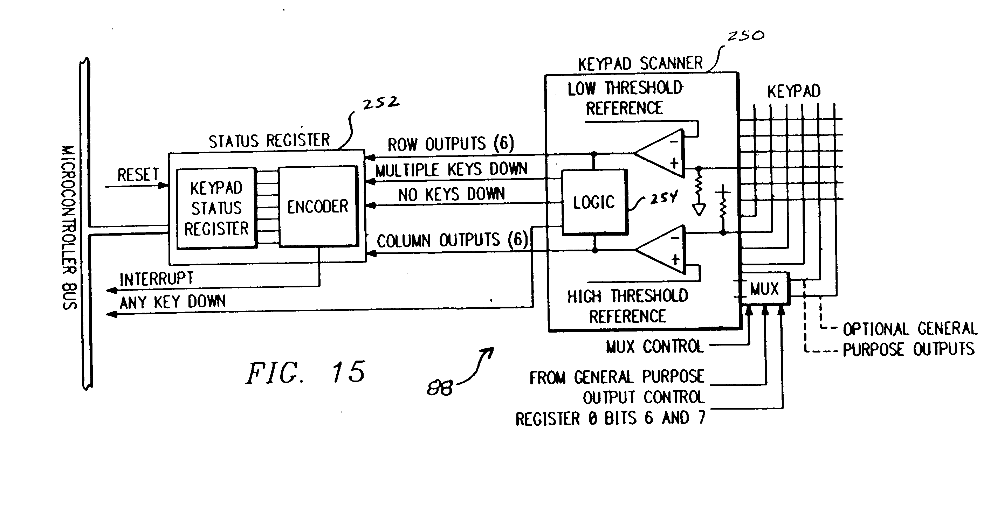

FIG. 11 shows the organization of the watchdog timer used in the exemplary IC incorporating the WPUD method and mechanism of the present invention.

The timer chain comprises a two second counter 200 and a two millisecond pulse generator 202. A 1Khz clock is received from the clock generator module 82 and fed to the disable control block. The clock output signal feeds the two millisecond pulse generator 202 and the two second counter 200. The terminal count output of the two second counter 200 is fed to the pulse generator 202 to initiate the generation of a two millisecond pulse.

The watchdog key mechanism consists of a user visible register 204 and a state machine 206. The user visible register 204 is written periodically by software to indicate that the software is functioning normally. The state machine 206 verifies that the register is updated correctly, generating a clear strobe to the two second counter 200 if all is well, and an error strobe to the two millisecond counter 202 if the register is updated incorrectly.

The watchdog key register 204 is the access point where software clears the watchdog timer 46. A sequence of two writes is required to clear the timer 46. In the exemplary IC, this sequence must be performed every two seconds to prevent the generation of a system reset.


SYSTEM CONTROL--PARALLEL PORT

The parallel I/O port of the exemplary IC consists of the microcontroller port 1 interrupt structure, a 11-bit general purpose output latch, 2 tri-level input pins, and three external interrupt inputs. The RxD and TxD pins in microcontroller port 3 can also operate as general purpose I/O ports. These ports are organized as discussed immediately below.

With respect to the microcontroller port P1.0 - P1.7, maskable interrupts are programmably generated on one edge of each pin. In the exemplary IC, for interrupt reporting purposes, the pins are divided into three separate interrupt source registers, one for P1.7-4, one for P1.3-2, and one for P1.1-0.

The general purpose outputs, of which there are 11, are programmed via the general purpose outputs registers 0 and 1. The outputs all default high.

The two tri-level input single pins can report three input states, high, low, or open. Typical applications are dial type selection and factory test mode selection. Additionally, as discussed in considerable detail above, TRI-LEVEL IN1 is used to select in-circuit emulation mode.

With respect to the external interrupt inputs, three input pins are provided that generate interrupt requests on both rising and falling edges. These pins can be used for hookswitch, channel synthesizer lock-up, and modem synthesizer lock-up inputs.

Functionally, all eight of the port 1 pins, when programmed as inputs, can generate maskable interrupts on edge transitions. The interrupt function is implemented in hardware separate from the microcontroller. FIG. 10 shows the basic structure of the interrupt function of the exemplary IC.

Referring to FIG. 12, the output latch of the exemplary IC provides 11 general purpose output pins for controlling external functions. This is a simple pair of registers (one 7-bit and one 4-bit) residing on the microcontroller data bus. When a bit is set in one of the registers (by software), the corresponding output pin is also set. When the bit is cleared, the pin is cleared. All pins that provide one of the general purpose outputs as their default state, default to a high level.

The multiplexing control for all pins except the keypad (OUT 6, 7) and tri-level input (OUT 10) is located in the module where their other function originates, not in the parallel port module (designated by reference numeral 208 in FIG. 12). The keypad and tri-level multiplexing is controlled in general purpose output register 1.

When the parallel I/O port is disabled, via a module enable control register 0 located in the clock generator module 82, all pins that are operating as general purpose outputs are placed in a high impedance state.

Continuing to refer to FIG. 12, two pins are provided in the exemplary IC that can detect three distinct input states: high, low, and open, or no connect. The state of the input is reported in an external interrupt

18

status register. These pins do not generate interrupt requests. The TRI-LEVEL IN1 pin is used primarily for selecting the operating mode of the IC after the RESET pin goes inactive. The TRI-LEVEL IN1 pin can be used as a general input in slight variations of the exemplary IC, but extreme care should be taken since a reset could cause the IC to enter the in-circuit emulation mode.

Referring still further to FIG. 12, three interrupt inputs are provided in the exemplary IC that generate interrupt requests on both rising and falling transitions. The status of each input pin is reported in a separate one-bit register. If a pin changes state since the last time its status register was read or reset, an interrupt request is latched and sent to the interrupt controller module. Reading the source register clears the latch and thus the interrupt request.

In general, in FIG. 12, it may be seen that the 11 outputs of the exemplary IC are independently controlled by their respective bits in the general purpose output control registers 0 and 1. Further, the input pins are pulled to mid-supply (Vcc/2) by pull-up and pull-down resistors when read. The pins each feed a separate pair of comparators. One is biased to produce a high at its output if the input is high, and one is biased to produce a high at its output if the input is low. If the input is open, both comparators output a low state. Still further, it may be noted that the pin logic should be designed to disable the pull-up and pull-down resistors when the state of the pin is not being evaluated. This is a power saving feature. The maximum resistance of the external input with respect to Vcc or Vss is 50 Ohms (when the input is high or low). The maximum capacitance is 50 pF.

Referring now to FIG. 13, there is shown a more detailed view of the external interrupt input structure of the exemplary IC in which the WPUD method and mechanism of the present invention may be included. It may be seen therein that this structure comprises three input pins 220, 222, 224, three status registers 226, 228, 230, and three transition detector latches 232, 234, 236.

The three external interrupt input status registers 226, 228, 230, which are one-bit registers, report the current status of the external interrupt input pins 220, 222, 224. The status bit changes as the pins change. Reading one of the registers clears the associated transition detector latch 232, 234, 236. The output of each latch 232, 234, 236 is fed to the interrupt controller module 86 where it is ANDed with an enable bit.

## SYSTEM CONTROL--SERIAL PORT

The serial interface of the exemplary IC is a combination of four serial channels. In the exemplary IC, these channels provide communication with frequency synthesizers, an LCD controller, an EEPROM, and a PCM codec test equipment. A combined set of transmit, receive, and clock logic is used to support the synthesizer, LCD, EEPROM, and PCM interfaces (see FIG. 12 wherein the transmit, receive and clock logic are generally designated by reference numerals 240, 242 and 246, respectively). This combined set of hardware is referred to as the SI/O interface.

With respect to the constructed synthesizer interface of the exemplary IC, it may be noted that communication between the IC and a synthesizer chip, e.g., an MB1501 synthesizer chip, is unidirectional. Communication goes only from the IC to the synthesizer.

With respect to the LCD interface of the exemplary IC, a serial interface is provided for communicating between the on-chip microcontroller and an NEC $\mu$PD7225 LCD controller IC, or the like. This is also a one direction interface, with communication going only from the IC to the LCD controller.

The EEPROM interface of the exemplary IC is bidirectional, and is compatible with 8- and 16-bit devices that support the National, General Instruments, Exel interface. Additionally, support for devices that output data on the falling edge of the clock is required. Thus, for compatibility with a wide variety of devices, the port can be programmed to receive data on the rising or falling edge.

With respect to the PCM test port of the exemplary IC, two special modes can be invoked from software that will convert the serial port to a codec or ADPCM transcoder test port. In codec test mode, the Data In pin becomes the 64 kbps codec receive input, the Data Out pin becomes the 64 kbps codec transmit output, and the Clock pin becomes a gated 512 Khz PCM data clock output (bursts of eight cycles at the 8 Khz frame rate). In ADPCM test mode the Data In pin becomes the 64 kbps ADPCM transmit input (PCM data input), the Data Out pin becomes the 64 kbps ADPCM receive output (PCM data output), and the Clock pin becomes the 512 Khz PCM data clock output (eight bit bursts at the 8 Khz frame rate). The B/D channel port provides the 8 Khz frame sync clock. The 64 Khz data clock must be synchronized to the 8 Khz frame sync.

The PCM test port of the exemplary IC does not use the serial I/O port's transmit buffer, receive buffer, or clock generator. The audio path logic provides the clock and a serial transmit bit stream, and receives the receive data in serial form. In other words, the PCM test function uses the serial I/O port pins, but the logic to support clock generation, clock synchronization, serial to parallel, and parallel conversion is handled within the audio path logic.

## SYSTEM CONTROL--KEYPAD SCANNER

The keypad scanner of the exemplary IC in which the WPUD method and mechanism of the present invention may be included provides the ability to support keypads of up to 36 keys. This keypad scanner operates in two modes: 1) activity detect, and 2) normal.

In the activity detect mode, it is not necessary to determine which key is depressed, only that a key has been depressed. This allows the IC to wake up from shut-down mode when the user presses a key. An output is generated to the clock generator module 82 when activity is detected while the IC is in shut-down mode.

In normal mode, the identity of the depressed key is determined and reported. Debouncing is the responsibility of the user software. An interrupt is generated when activity is detected, e.g., when a key is closed. Typically, the user responds to the interrupt by masking the keypad interrupt, setting a microcontroller timer (debounce time is typically 4 to 16 milliseconds), and returning from the interrupt. When the timer expires an interrupt is generated. This causes the user to read a keypad status register, which at this time contains the stable identity of the depressed key. This status includes a no keys down code (00000000), a multiple keys down code (0XXXXXX1), and codes for each of the keys (0RRRCCC0); R = row code, C = column code, and X = don't care.

FIG. 15 shows a block diagram of the keypad scanner. The module is comprised of the scanner unit 250 and the keypad status register 252.

The scanner 250 contains row and column input pins and comparators, and a block of logic 254 that detects the no keys down, multiple keys down, and any key down conditions.

The status logic formats the inputs from the scanner, and presents this status to the user. More specifically, keypad status logic comprises the following:

Inputs
●6 row comparator outputs
●6 column comparator outputs
●No keys down output
●Multiple keys down output
●microcontroller Read strobe
●microcontroller data bus
●Register select strobe from address decoder module

Outputs
●Register drives the internal data bus when accessed by the address decoder module.
●An interrupt request is generated whenever the value of the register changes. This interrupt request is connected to interrupt controller.

Encoder
●The six row and six column signals are encoded into two three-bit words (octal to binary encoding). This is combined with The no keys down and multiple keys down indications to form a seven-bit word. Bit 7 of the register is always 0.

## SYSTEM CONTROL--REAL-TIME CLOCK

A real-time clock is provided on the exemplary IC. This clock 74 (see FIG. 3a) operates from the normal IC supply while the IC is powered on, and from a dedicated battery when the IC is powered down. A 32.768 kHz crystal is connected to the real-time clock. Additionally, a 1k byte block of RAM is provided. This "on-chip" RAM is independent from the real-time clock except that it is powered from the real-time clock's BATT IN pin.

FIG. 16 shows a block diagram of the real-time clock module 74 of the exemplary IC.

## SYSTEM CONTROL--BATTERY LEVEL DETECTOR

The exemplary IC includes a mechanism providing a digital represent tion of the power supply (i.e., battery) voltage level over a range of 2.7 to 5.5 volts.

Functionally, the battery voltage monitor circuit compares the voltage on a Vcc pin to an internal threshold voltage. If Vcc is above the threshold voltage, the comparator output is high. If Vcc is below the threshold, the comparator output is low. In the exemplary IC, the internal threshold voltage is programmable via a 4-bit code from 2.7 Volts to 5.4 Volts, with an accuracy of ±5%.

FIG. 17 is a block diagram of the battery level detector module of the exemplary IC.

OPERATING MODES

Generally describing the operating modes of the IC shown in FIG. 3, it may be noted initially that the IC has three basic modes of operation. Those three modes are an in-circuit emulation mode, a normal mode, and a test mode. Generally, the in-circuit emulation capability mode disables the on-chip microcontroller (designated by reference numeral 40 in FIG. 3), allowing an external ICE to be used for software development and software and hardware debugging. The normal mode is the mode in which the product containing the IC is operated by the end user. A final mode of operation, the test mode, is basically the same as the normal mode, except that in the test mode it is possible to also enable internal test functions of the IC.

Entry into the three operating modes is controlled by the state of the reset pin 42 and the tri-level IN1 (TRI1) pin 44. Although those pins 42, 44 could effect such selection in a number of different ways, one way would be to have the state of the TRI1 pin be monitored and acted upon by the IC when the reset pin 42 goes inactive. If the TRI1 is low, for example, the in-circuit emulation capability mode could be activated. At a mid supply or no-connect point, the test mode could be activated. Finally, when the TRI1 pin is high and, again, when the reset pin 42 goes inactive, the IC could operate in the normal mode.

In this exemplary IC, the in-circuit emulation capability mode is triggered at reset if, when the reset pin 42 goes high, the tri-level input 1 pin 44 is low. Further, all interval connections to I/O ports of the exemplary IC are routed from the microcontroller (i.e., "off-chip"), with the exception of the clock connected to the timer 0 and timer 1 inputs (this clock can be external to the IC). ALE and PSEN/ then become inputs. The clock input to the microcontroller, which is routed off chip, is forced on at reset in in-circuit emulation capability mode. The watchdog timer 46 does not operate in this mode.

When the IC shown in FIG. 3 (which IC, it should be noted, depicts an exemplary embodiment of the present invention) is placed in the in-circuit emulation capability mode, a number of pins shown in FIG. 3 change function. Specifically, in the in-circuit emulation capability mode, the following pins change function as described below:

| PIN | USE IN ICE MODE |
| --- | --- |
| INT0/OUT, CSOUT0/ | INT0/OUT |
| INT1/OUT, CSOUT1/ | INT1/OUT |
| CPUCLKOUT, CSOUT2/ | CPUCLKOUT |
| ALE I/0, OUT9 | ALE INPUT |
| RD/ | RD/ INPUT |
| WR/ | WR/ INPUT |
| ADDR15-8 | ADDR15-8 INPUTS |
| ADDR/DATA7-0 | ADDR/DATA7-0 - ADDRESSES = INPUTS DATA I/O = O/I |
| P1.6-0 | HIGH-Z |
| P1.7 | INPUT |
| P3.1-0 | HIGH-Z |

REGISTERS

Because of the level of sophistication of those skilled in the art and the degree of detail shown in FIGs. 3-5, no attempt will be made herein to precisely describe the functions of each pin and register within the exemplary IC shown. Such a description is simply not necessary for those skilled in the relevant art to obtain a full understanding of all of the inventive aspects of the present invention. Further, reference may be had to the various related applications for further specifics about these and other aspects.

CT2

The CT2 portion of an exemplary IC which incorporates the WPUD method and mechanism of the present invention may include the following modules: FIFOs 90, a B/D Channel Port (see FIG. 3b), a transmit modem 100, an RSSI A/D Converter 92, and a logic module 96.

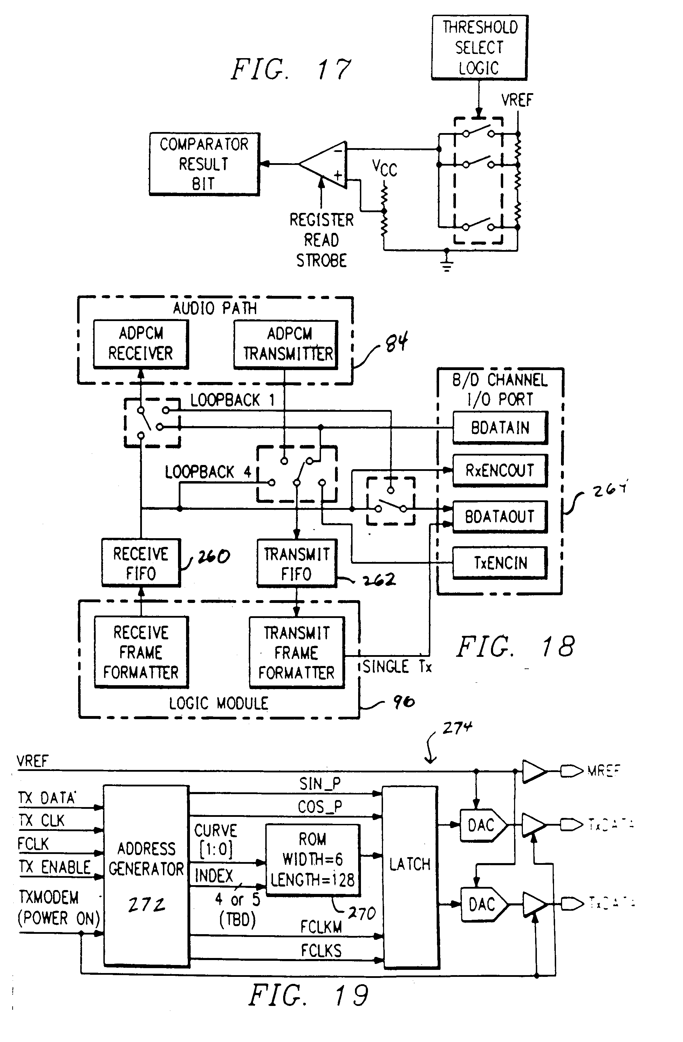

In the exemplary IC, two unidirectional FIFOs 260, 262 are provided between the ADPCM block 84, the B channel I/O 264, and the frame formatter 96, with one in the transmit direction and one in the receive direction 262 (see FIG. 18). These FIFOs provide an elastic store between the 72 kbps radio burst rate and the constant 32 kbps ADPCM, B channel port rate. The FIFOs appear to be serial when viewed from the frame formatter 96, and 4 bits wide when viewed by the ADPCM block 84 because the ADPCM operates on nibbles.

The FIFO module 90 in the exemplary IC builds 512 kHz, 32 kHz, and 8 kHz clocks from either a 1.152 MHz clock from the logic module 96, (specifically, a PLL1152) or a fixed 1.152 MHz clock from the clock generator module 82.

The B/D Channel I/O Port module 264 in the exemplary IC provides six I/O pins that are multiplexed to serve four separate functions: a B channel I/O port, including encryption; a D channel I/O port; a single transmit (Tx Modulator I/O); and six general purpose output ports.

The transmit modulator 100 of the exemplary IC accepts serial data from the CT2 logic module 96 and converts it to a quadrature pair of single-ended analog outputs. The outputs generated in the exemplary IC are intended to be externally mixed with an IF carrier and summed to obtain the desired frequency modulated signal.

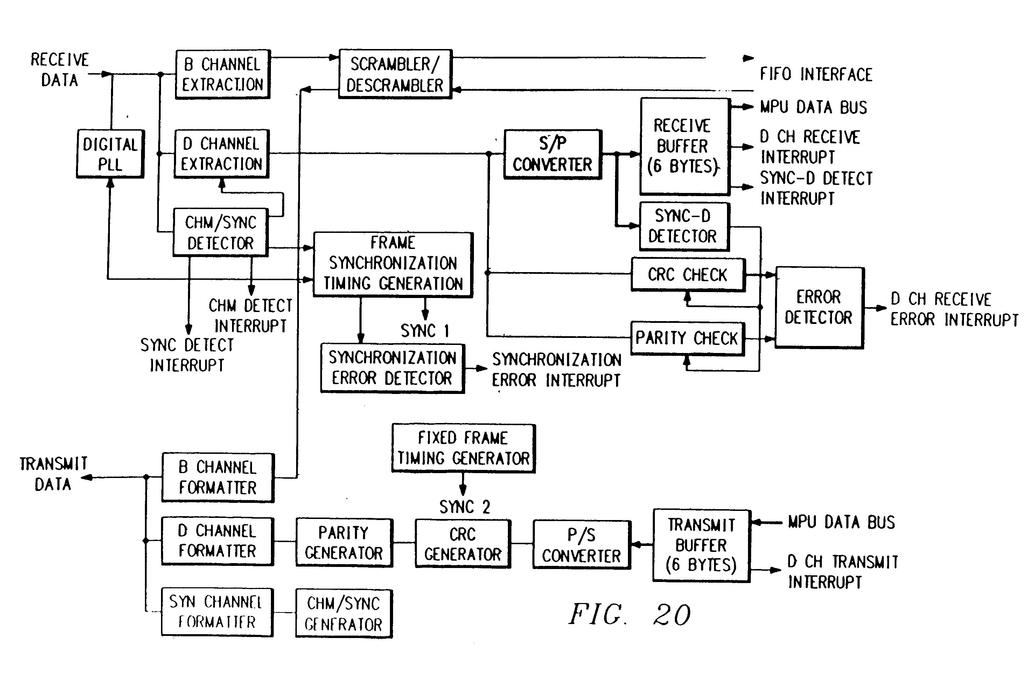

A block diagram of the modulator 100 is shown in FIG. 19. The heart of the modulator 100 is a look-up ROM 270 addressed by a data dependent state machine address generator 272 and followed by a series of synchronizing latches 274. Two identical 6-bit + sign DAC's followed by buffers drive the analog outputs.

As discussed in much greater detail in various of the related applications, a test mode may be provided in the exemplary IC to simplify spectral measurements.

The receive signal strength indication (RSSI) module 92 provides a digital representation of the RF receive signal level.

Discussing now generally the logic module 96, a frame controller is provided which comprises a receive timing recovery, a frame timing generator, a SYNC channel handler, a B channel handler, a D channel handler, and a modem timing adjustment.

FIG. 20 is a block diagram of the frame controller, including the receive timing recovery, frame timing generator, SYNC channel handler, B channel handler, D channel handler.

With regard to the receive timing recovery function, bit synchronized timing from the receive data (Rx Data) is generated and fed to the various functions.

The SYN channel handler receives a burst signal and the PLLed clock from the receive clock generator (DPLL) and it gives received sync information to the frame timing generator and the CPU. It also receives transmit timing pulses from the frame timing generator, transmit data from the B channel handler and the D channel handler and it generates a transmit burst signal.

The frame timing generator receives received synchronization information from the syn channel handler when the system is receiving a signal, gives all the necessary receive and transmit timing pulses to the B channel handler, the D channel handler, the SYN channel handler of the transmit portions, MODEM timing adjustment, and any other blocks where those pulses are required.

The modem timing adjustment measures the delay of the modem and the RF section when they are transmitting and receiving a reference signal from the modem.

CORDLESS TELEPHONE APPLICATION

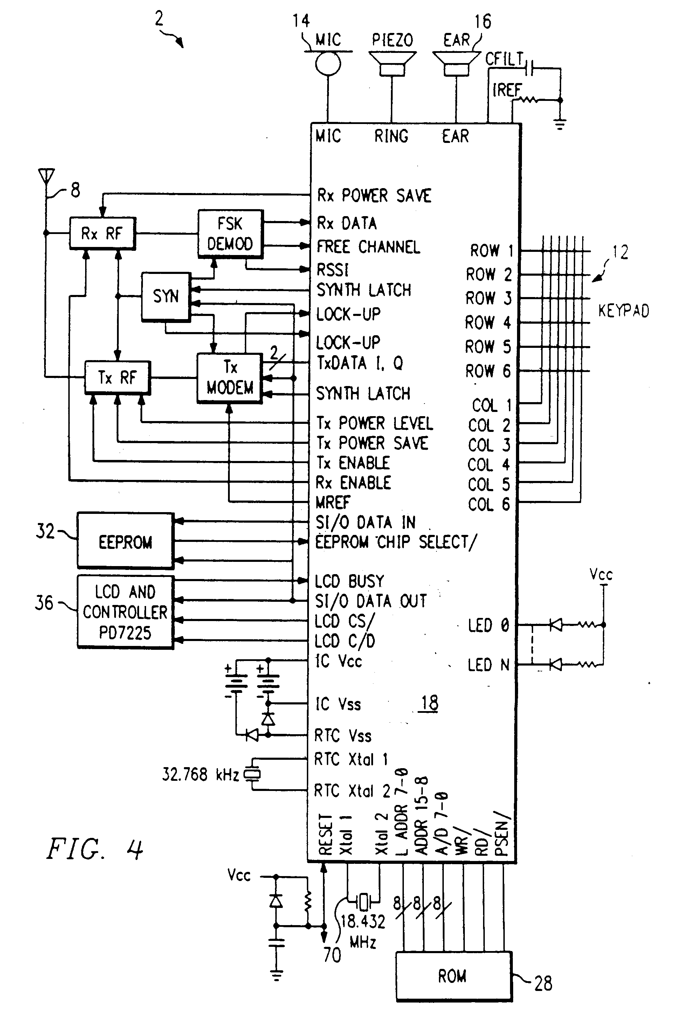

As previously discussed, the WPUD method and mechanism of the present invention is well-suited for use in an IC including a microcontroller, which IC is for use in a cordless telephone. Referring now to FIGS. 4 and 5, shown therein is a cordless telephone of a type into which IC's including the WPUD method and mechanism according to the teachings of the present invention, for example, the exemplary IC previously described, may be incorporated. Such a cordless telephone includes a handset or terminal unit 2 (shown in FIG. 4) and a base unit or base station 4 (shown in FIG. 5). Base unit 4 is connected by a telephone cord to an outlet or receptacle in a wall, a telephone pole, or another fixed structure, so that it may both receive and transmit telephone message signals through a telephone network line 6 and so that it also may be powered thereby. An antenna 8 on the handset 2, and a corresponding antenna 10 on the base station 4 are used to create a communication channel between the two units by the transmission and reception of radio waves.

As is conventional, handset unit 2 includes a keypad 12 for making or dialing outgoing calls, and a mouthpiece and an earpiece, with which a microphone 14 and a loudspeaker 16 are, respectively, associated. A telephone number may be entered on the keypad 12, and corresponding information is transmitted over the communication channel to base unit 4, and thence to the telephone network line 6. Alternatively, when base unit 4 receives a message signal from the telephone network line 6 indicating that an incoming call is present, a signal from base unit 4 causes a ringing sound in handset unit 2 and a second ringing sound in base unit 4 to indicate the existence of the incoming call.

The standard maximum separation of such a handset unit 2 and base unit 4, which is called the service area, is about 300 meters, and is set by the Federal Communications Commission (FCC). Typically, there are ten duplex channels permitted for each system with the upper channel having a frequency in the 49 MHz band and the lower channel having a frequency in the 46 MHz band. Of course, such operating parameters are set by the FCC and do not form a part of the present invention.

The base station 4, like the handset 2, comprises a microphone 22, an ear piece 24, and a keypad 26. Likewise, both the handset 2 and the base station 4 include a ROM 28, 30, an EPROM 32, 34, an LCD and controller 36, 38, as well as a number of other elements which generally relate to the radio signals and power levels.

As may also be seen in FIGS. 4 and 5, an IC including the WPUD method and mechanism according to the teachings of the present invention is used in both the handset unit 2 and the base station 4. The IC is designated by reference numeral 18 in FIG. 4 and by reference numeral 20 in FIG. 5.

Based upon the foregoing, those skilled in the art should now fully understand and appreciate the improvements made by the teachings herein. Those skilled in the art should also fully understand and appreciate the value and merits of the WPUD method and mechanism described herein which may be incorporated in an IC having a microcontroller and, in particular, in such an IC for use in cordless telephones. On virtually every point made herein, however, further details may be found in the related cases listed in the cross-reference to related applications section above. Although those details are not necessary for those skilled in the art to practice the present invention or to comprehend its best mode of practice, those details may be useful to those skilled in the art and they may wish to refer to them.

Obviously, numerous modifications and variations are possible in light of the teachings herein. Accordingly, within the scope of the appended claims, the present invention may be practiced otherwise than as specifically described above.

### Claims

1. An integrated circuit comprising:
   a microcontroller having at least one output buffer with a weak pull-up; and
   a means for disabling said pull-up.

2. The integrated circuit of claim 1, wherein said means for disabling is incorporated in the circuitry of the integrated circuit.

3. The integrated circuit of claim 1, wherein said means for disabling when activated eliminates the need far a driver to sink current of said pull-up.

4. The integrated circuit of claim 1, wherein said microcontroller is an 8051 microcontroller having output buffers with said pull-ups on Ports 1, 2 and 3.

5. The integrated circuit of claim 1, wherein said means for disabling is activated through software control.

6. The integrated circuit of claim 1, wherein said at least one output buffer with a weak pull-up is configured with a port pin.

7. The integrated circuit of claim 6, wherein said means for disabling is activated through software control, said software control activating said means for disabling by configuring said port pin with a corresponding port control register bit to an appropriate value.

8. A method for reducing power consumption by an integrated circuit incorporating a microcontroller, comprising the step of disabling a weak pull-up associated with an output buffer of said microcontroller

**9.** The method of claim 8, wherein said step of disabling is by software control.

**10.** The method of claim 8, wherein said step of disabling is by configuring a port pin associated with said buffer with a corresponding port control register bit to an appropriate value.

**11.** The method of claim 8, further comprising the step of eliminating a driver which serves to sink the current of said pull-up in input mode.

FIG. 1

NMOS Configuration

CMOS Configuration

FIG. 2

FIG. 3a

27

FIG. 3b

FIG. 4

FIG. 5

FIG. 6

FIG. 7

MAIN INTERRUPT
SOURCE REGISTER 0

MAIN MASK
REGISTER 0

*182*

| BIT0 | BIT0 |
| BIT1 | BIT1 |
| BIT2 | BIT2 |
| BIT3 | BIT3 |
| BIT4 | BIT4 |
| BIT5 | BIT5 |
| BIT6 | BIT6 |

D CHANNEL
STATUS
REGISTER

D CH RX

D CH Rx ERROR

D CH TX

PARALLEL PORT — EXT INT1 (SYNTHESIZER LOCK-UP)

PARALLEL PORT — EXT INT2 (MODEM LOCK-UP)

NOT USED

NOT USED

INTO

*178*

MAIN INTERRUPT
SOURCE REGISTER 1

MAIN MASK
REGISTER 1

| BIT0 | BIT0 | PARALLEL PORT |
| BIT1 | BIT1 | KEYPAD SCANNER |
| BIT2 | BIT2 | SERIAL PORT |
| BIT3 | BIT3 | CHM/SYNC |
| BIT4 | BIT4 | PARALLEL PORT |
| BIT5 | BIT5 | PARALLEL PORT |
| BIT6 | BIT6 | PARALLEL PORT |
| BIT7 | BIT7 | REAL-TIME CLOCK |

EXT INT0 (HOOKSWITCH)

KEYPAD STATUS

KEYPAD ANY KEY DOWN

SIO RX

SI/O TX

CHM/SYNC
INTERRUPT
SOURCE
REGISTER

MASK
REGISTER

CH MARKER

SYNC

SYNC-D

SYNC ERROR

PORT P1.0-P1.1

PORT P1.2-P1.3

PORT P1.4-P1.7

RTC TIMER

RTC ALARM

RTC UPDATE END

SHUT-DOWN

CLEARED WHEN MAIN ISR IS READ

INT1

*180*

*184*

S
R

FIG. 8

FIG. 9

FIG. 10

FIG. 11

FIG. 12

FIG. 13

PCM TRANSMIT DATA

PCM CLOCK (512 KHz BURST)

PCM RECEIVE DATA

SERIAL DATA OUT

8

SERIAL CLOCK OUT

TRANSMIT CLOCK

SYNTHESIZER, LCD, EEPROM TRANSMIT BUFFER

240

Tx BUFFER EMPTY

CLOCK OUT

PROGRAMMABLE LENGTH COUNTER

CLOCK GENERATOR, MODE SELECT

SERIAL DATA IN

EEPROM RECEIVE BUFFER

8

RECEIVE CLOCK

S I/O CLOCK

8

Rx DATA AVAILABLE

244

*FIG. 14* 242

MICROCONTROLLER DATA BUS

32.768 KHz

OSCILLATOR

32

32

32

1 KHz

TIMER INTERRUPT

INTERRUPT OUTPUT

DIVIDER CONTROL

CONTROL REGISTERS

RTC BATTERY

MAIN BATTERY

CLOCK/CALENDAR UPDATE

BINARY/BCD INCREMENT

CLOCK, ALARM, AND CALENDAR REGISTERS

MICROCONTROLLER DATA BUS

IC V$_{CC}$

IC V$_{SS}$

RTC V$_{SS}$

V$_{min}$

*FIG. 16*

FIG. 15

*FIG. 17*

THRESHOLD
SELECT
LOGIC

VREF

COMPARATOR
RESULT
BIT

−
+

V_CC

REGISTER
READ
STROBE

AUDIO PATH

ADPCM
RECEIVER

ADPCM
TRANSMITTER

*84*

B/D CHANNEL
I/O PORT

LOOPBACK 1

BDATAIN

RxENCOUT

LOOPBACK 4

BDATAOUT

*264*

RECEIVE
FIFO

*260*

TRANSMIT
FIFO

*262*

TxENCIN

RECEIVE
FRAME
FORMATTER

TRANSMIT
FRAME
FORMATTER

SINGLE Tx

*FIG. 18*

LOGIC MODULE

*96*

*274*

VREF

MREF

TX DATA

SIN_P

TX CLK

COS_P

FCLK

ADDRESS
GENERATOR

*272*

CURVE
[1:0]

ROM
WIDTH=6
LENGTH=128

LATCH

DAC

TxDATA

TX ENABLE

INDEX

TXMODEM
(POWER ON)

4 or 5
(TBD)

*270*

FCLKM

DAC

TxDATA

FCLKS

*FIG. 19*

FIG. 20

FIG. 21

FIG. 22

EP 0 580 337 A2